(19) Europäisches Patentamt
European Patent Office
Office européen des brevets

(11) **EP 4 496 213 B1**

(12) **EUROPEAN PATENT SPECIFICATION**

(45) Date of publication and mention
of the grant of the patent:
**06.05.2026   Bulletin 2026/19**

(21) Application number: **23770255.0**

(22) Date of filing: **16.02.2023**

(51) International Patent Classification (IPC):
**B60L 3/00** *(2019.01)*      **H02P 29/024** *(2016.01)*
**B60L 3/04** *(2006.01)*      **B60L 15/20** *(2006.01)*
**G01R 31/327** *(2006.01)*

(52) Cooperative Patent Classification (CPC):
**B60L 15/20; B60L 3/0038; B60L 3/04;**
**H02P 29/024;** G01R 31/3278

(86) International application number:
**PCT/JP2023/005533**

(87) International publication number:
**WO 2023/176295 (21.09.2023 Gazette 2023/38)**

(54) **DIAGNOSTIC DEVICE AND PROGRAM**

DIAGNOSEVORRICHTUNG UND -PROGRAMM

DISPOSITIF ET PROGRAMME DE DIAGNOSTIC

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **16.03.2022   JP 2022041622
10.01.2023   JP 2023001960**

(43) Date of publication of application:
**22.01.2025   Bulletin 2025/04**

(73) Proprietor: **DENSO CORPORATION
Kariya-city, Aichi 448-8661 (JP)**

(72) Inventors:
• **KOBAYASHI, Kazuki**
**Kariya-city, Aichi 448-8661 (JP)**
• **CAO, Junmin**
**Kariya-city, Aichi 448-8661 (JP)**
• **TAKEMURA, Yuichi**
**Kariya-city, Aichi 448-8661 (JP)**

(74) Representative: **TBK
Bavariaring 4-6
80336 München (DE)**

(56) References cited:
JP-A- 2006 280 070      JP-A- 2009 183 134
JP-A- 2009 229 291      JP-A- 2014 045 578
JP-A- 2020 018 157      JP-A- 2021 058 054
US-A1- 2011 221 374      US-A1- 2013 106 423

**Description**

[TECHNICAL FIELD]

This disclosure relates to a diagnostic device and a program for diagnosing power switch on-failure state.

[BACKGROUND ART]

A conventional power supply system is known. The conventional power supply system has a power supply, an inverter, a motor, a power switch (system main relay) that connects or disconnects between the power supply and the motor in a power supply path connecting the power supply and the inverter. In addition, a device for diagnosing the welding of the power switch while the motor is rotating and driven for this power supply system is also known.

For example, the device described in patent document 1 controls the inverter so that the path voltage, which is the voltage of the power supply path on the inverter side rather than the power switch, becomes the predetermined target voltage while outputting a shutdown command to shut down the power switch when a power failure is detected., the device diagnoses the welding of the power switch based on whether the path voltage becomes the target voltage.

[PRIOR ART REFERENCES]

[PATENT DOCUMENT]

[Patent Document 1] JP2009-183134A

Document US 2011 / 221374 A1 discloses a discharging control device for an electric power conversion system, which is mounted on a motor vehicle. The discharge control device turns off a relay in order to instruct an electric power conversion circuit to supply a reactive current into a motor generator, and thereby to decrease a capacitor voltage to a diagnostic voltage. After this process, the discharge control device outputs an emergency discharging instruction signal in order to turn on both power switching elements at high voltage side and a low voltage side in the electric power conversion circuit. This makes a short circuit between the electrodes of the capacitor in order to discharge the capacitor, and executes a discharging control to detect whether or not an emergency discharging control is correctly executed and completed. The discharge control device detects whether or not the electric power stored in the capacitor is discharged on the basis of the voltage of a voltage sensor.

Document JP 2006 280070 A discloses a control method and a controller of a motor. In the controller of a motor comprising a relay for interrupting power supply, a switching circuit of the relay for interrupting power supply, a preliminary charging circuit and a relay for switching the preliminary charging circuit, a switching circuit of the relay for switching the preliminary charging circuit, a capacitor for smoothing a power supply, and an inverter circuit for controlling the motor, if a voltage not lower than some threshold V1 is remaining in the capacitor for smoothing the power supply when both switching circuits for turning the relay for interrupting power supply and the relay for switching the preliminary charging circuit off are operating, charges remaining in the capacitor for smoothing the power supply are conducted to the motor through the inverter circuit for controlling the motor and discharged. If the voltage difference before and after discharge is not higher than a threshold V2, a decision is made that the relay for interrupting power supply is deposited.

Document US 2013/106423 A1 discloses a main relay monitoring system and method for a green vehicle, where a main relay is installed between a high voltage battery and an inverter in order to diagnose whether the main relay, which controls the output of the high voltage battery, is fused. In particular a switching operation of an inverter is stopped when an ignition off is detected, and a main relay is turned off and a voltage output of a main battery is cut. Then, a voltage charged at a DC link capacitor is forcibly discharged once the main relay is completely turned off. A voltage of the main battery is then compared to an input voltage of the inverter, and a determination is made based off of this comparison whether the main relay is fused.

[SUMMARY OF INVENTION]

When the motor is rotating, a back EMF is generated in proportion to the rotation speed of the motor. Therefore, to bring the path voltage near the target voltage by controlling the inverter, it is necessary to control the inverter to cancel the back EMF of the motor. As a result, configuration of the device and control procedure of the inverter become more complicated. Therefore, a technology that can properly diagnose an on-failure state of the power switch without changing the path voltage by inverter control is desired.

The present disclosure was made to solve the above problem, the purpose of which is to provide a diagnostic device and program that can properly diagnose an on-failure state of a power switch.

This object is solved by a diagnostic device as set out in claim 1 as well as by a program as set out in claim 9.

Advantageous developments are defined in the dependent claims.

The first means to solve the above problem applies to a diagnostic device applicable to a power supply system, the power supply system including: a power supply; an inverter connected to the power supply, a motor connected to the inverter, a power switch on a power supply path connecting the power supply and the inverter, a voltage sensor that detects a path voltage, the path voltage being a voltage of the power supply path on the inverter side of the power switch. The diagnostic device includes: a shutdown command unit that outputs a shutdown command to shut down the power switch with the control of the inverter stopped when a switch diagnostic condition is satisfied in the conduction state of the power switch, an acquisition unit that acquires a voltage change, which is the change in the detected voltage of the voltage sensor in response to the change in the number of revolutions of the motor after the output of the shutdown command by the shutdown command unit, a diagnostic unit that diagnoses whether the power switch is in an on-failure state based on the voltage change.

In the above configuration, when the switch diagnosis condition is satisfied in the conduction state of the power switch, a shutdown command is output to shut down the power switch with the control of the inverter stopped. The voltage change, which is the amount of change in the detected voltage of the voltage sensor in response to the change in the number of revolutions of the motor that occurs after the output of the shutdown command, is acquired, and the on-failure state of the power switch is diagnosed based on the voltage change. Here, when the power switch is normal, the path voltage on the inverter side (voltage of the power supply path on the inverter side of the power switch) after the shutdown command output depends on the back EMF voltage of the motor, and after the shutdown command output if the number of revolutions of the motor changes after the shutdown command is output, it changes in response to the change in the number of revolutions. On the other hand, when the power switch is in the on-failure state, the path voltage on the inverter side after the shutdown command output does not change corresponding to the change in the number of revolutions even if the number of revolutions of the motor changes after the shutdown command output. Therefore, there is no change in the path voltage on the inverter side after the output of the shutdown command. Therefore, the on-failure state of the power switch can be properly diagnosed by comprehending the voltage change corresponding to the change in the number of revolutions of the motor that occurs after the shutdown command output. In addition, the above configuration diagnoses the on-failure state of the power switch while the inverter control is stopped, which enables switch failure diagnosis with a simple configuration without causing voltage changes due to inverter control.

Furthermore, in the above first means, the power supply system rotates the propeller by the motor in an aerial vehicle that flies with the rotation of the propeller, the diagnostic device further includes a propeller rotation control unit, when the shutdown command is output by the shutdown command unit, reduces the number of revolutions of the motor along with the number of revolutions of the propeller.

According to the above configuration, the number of revolutions of the motor decreases along with the number of revolutions of the propeller in the aerial vehicle, which can cause the desired voltage decreasing required for power switch failure diagnosis on the inverter side.

Furthermore, in the above first means, the propeller rotation control unit, after the shutdown command is output and the diagnostic unit diagnosed, when the power switch is determined to be normal and there is a request to increase the number of revolutions of the propeller, cancels the reduction in the number of revolutions of the propeller.

According to the above configuration, when the power switch is determined to be normal and there is a request to increase the number of revolutions of the propeller, the state of decreased number of revolutions of the propeller is released, so that after the power switch failure diagnosis, the flight the flight of the aerial vehicle can be suitably restored to its pre-diagnosis flight state after the power switch failure diagnosis.

In the second means, in the power supply system, a smoothing capacitor is connected in parallel to the power supply in the power supply path on the inverter side than the power switch, the diagnostic device further includes a discharge processing unit that discharges the smoothing capacitor under the condition that a decrease in the number of revolutions occurs after the output of the shutdown command by the shutdown command unit, and the acquisition unit acquires the difference between the detected voltage before the discharging of the smoothing capacitor by the discharging processing unit and the detected voltage after the discharging of the smoothing capacitor as the voltage change under the situation where the number of revolutions decreases after the output of the shutdown command.

The provision of a smoothing capacitor in the power supply system can stabilize the path voltage. On the other hand, if a smoothing capacitor is provided in the power supply system, it may hinder the monitoring of voltage changes on the inverter side. In this regard, in the above configuration, the smoothing capacitor is made to discharge under the situation where the number of revolutions of the motor decreases after the output of the shutdown command. This allows the path voltage on the inverter side to be set to the voltage corresponding to the number of revolutions of the motor after the output of the shutdown command, and the failure in the on-state of the power switch can be properly diagnosed.

In the third means, the discharge processing unit discharges the smoothing capacitor to make the path voltage lower than an electromotive force voltage of the motor at the end of the smoothing capacitor discharge.

At the end of the smoothing capacitor discharge, the path voltage is recharged to the motor's EMF voltage. In this case, if the path voltage at the end of the smoothing capacitor discharge is higher than the EMF voltage of the motor, the voltage change corresponding to the change in the number of revolutions of the motor cannot be determined. On this point, since the smoothing capacitor is discharged so that the path voltage becomes lower than the electromotive force voltage of the motor at the end of the smoothing capacitor discharge, the voltage change corresponding to the change in the number of revolutions of the motor can be properly determined, and thus the power switch this allows for proper diagnosis of power switch failures.

In the fourth means, the discharge processing unit discharges the smoothing capacitor multiple times under the situation where the number of revolutions decreases after the output of the shutdown command, the acquisition unit acquires, when the smoothing capacitor is discharged multiple times, the number of revolutions and the path voltage before the first discharge of the smoothing capacitor and after each discharge after the first discharge, respectively, the diagnostic unit calculates an approximate straight-line, which is a linear approximation of the relationship between the number of revolutions and the path voltage, using the number of revolutions and the path voltage in three or more combinations acquired by the acquisition unit, and diagnoses the on-failure state of the power switch based on the slope of the approximate straight-line and the scatter of the path voltage relative to the approximate straight-line.

For example, even when the power switch is in the on-failure state, the path voltage may change due to detection errors or noise from the voltage sensor. In this case, the voltage change may be large, and there is concern that the on-failure state of the power switch may be missed in the diagnosis. In this regard, in the above configuration, under the situation where the number of revolutions of the motor decreases after the power switch shutdown command is output, the smoothing capacitor is discharged multiple times, and an approximate straight-line is calculated from the number of revolutions and path voltage acquired for each capacitor discharge. The approximate straight-line is calculated from the number of revolutions and path voltage acquired for each capacitor discharge. Based on the slope of the approximate straight-line and the scatter of the path voltage relative to the approximate straight-line, the on-failure state of the power switch is diagnosed. In this case, the reliability of the slope of the approximate straight-line can be determined based on the scatter of the path voltage to the approximate straight-line, and the slope of the approximate straight-line can be used to properly diagnose the on-failure state of the power switch.

In the fifth means, the acquisition unit acquires the number of revolutions and the path voltage before and after the first capacitor discharge by the discharge processing unit as first data and second data respectively, under the condition that the number of revolutions decreases after the output of the shutdown command, and then acquires the number of revolutions and the path voltage after the second capacitor discharge as third data, the diagnostic unit, in a case that the number of revolutions of the motor is higher than the predetermined value when the second data is acquired, acquires the first to third data and diagnoses the on-failure state of the power switch using the first to third data, and in a case that the number of revolutions of the motor is lower than the predetermined value when the second data is acquired, acquires the first data and the second data and diagnoses the on-failure state of the power switch using the first data and the second data.

When multiple discharges of the smoothing capacitor are performed and the on-failure state of the power switch is diagnosed based on an approximate straight-line calculated from the number of revolutions and path voltage for each capacitor discharge and the scatter of the path voltage relative to the approximate straight-line, the accuracy of failure diagnosis can be improved. State of the power switch based on the approximate straight-line calculated from the number of revolutions and the path voltage for each capacitor discharge and the scatter of the path voltage relative to the approximate line, it is possible to improve the accuracy of failure diagnosis. In addition, if the motor is in a low rpm state, the number of revolutions change from that point may not be expected.

In this regard, when the number of revolutions of the motor is higher than the predetermined value at the time of acquiring the second data after the first capacitor discharge, the on-failure state of the power switch is diagnosed using the first to third data, while if the number of revolutions is lower than the predetermined value, the on-failure state of the power switch is diagnosed using the first and second data. This allows for proper fault diagnosis while considering the rotation state of the motor.

In the sixth means, the power supply system further includes a current sensor that detects the power supply current, which is the current flowing in the power supply, the acquisition unit acquires the detected current of the current sensor after the output of the shutdown command by the shutdown command unit, the diagnostic unit performs a first determination process to determine whether the voltage change is greater than a predetermined voltage threshold and a second determination process to determine whether the detected current is greater than a predetermined current threshold, and when the voltage change is determined to be smaller than the voltage threshold in the first determination process and the detected current is determined to be larger than the current threshold in the second determination process, the diagnostic unit diagnoses the power switch is in the on-failure state.

According to the above configuration, the first determination process using the voltage change and the second determination process using the detected current are executed, and when the voltage change is determined to be smaller than the predetermined voltage threshold in the first determination process and the detected current is determined to be larger than the current threshold in the second determination process, the power switch is diagnosed to be in the on-failure state. By diagnosing the on-failure state of the power switch using the voltage change and the detected current, the on-failure state diagnosis of a power switch can be performed more appropriately than when diagnosing the on-failure state of a power switch using only the voltage value.

In the seventh means, the power supply system is mounted to a mobile object having a plurality of drive units, each of the drive unit including an inverter, a motor, a power switch, and a voltage sensor, the mobile object can move by driving some of the drive units out of all the drive units, and the shutdown command unit, when some of the drive units out of a plurality of drive units in the drive state are to be stopped while the mobile object is moving, assumes that the switch diagnosis condition is satisfied for the drive unit to be stopped and outputs the shutdown command.

In the above configuration, when the moving object equipped with multiple drive units is moving and some of the drive units are stopped from the drive state, the switch diagnosis condition is assumed to be satisfied for the drive unit to be stopped and a shutdown command is output. In this case, the failure diagnosis of the drive unit in the drive stop state can be performed without affecting the moving status of the mobile object.

In the eighth means, a power control unit outputs a power command value to the drive unit to which the shutdown command is not output, when stopping the drive of some of the drive units during the movement of the mobile object, and the shutdown command is output by the shutdown command unit for the drive units to be stopped, the power command value being to maintain the state of movement of the mobile object.

According to the above configuration, when driving is stopped in any of the multiple drive units to perform the power switch failure diagnosis, the moving state of the mobile object remains unchanged before and after the driving is stopped. This makes it possible to perform failure diagnosis in the drive unit without affecting the moving status of the mobile object.

[Brief description of the drawing].

The above and other objects, features and advantages of the present disclosure will become clearer with the following detailed description with reference to the accompanying drawings. In the accompanying drawings:

Fig. 1 shows a diagram of the control system,
Fig. 2 shows a flowchart of the control process,
Fig. 3 shows a flowchart of the diagnostic process according to the first embodiment.
Fig. 4 shows a timing chart when the main relay is normal,
Fig. 5 shows a timing chart when the main relay is in an on-failure state,
Fig. 6A shows a slope of a path voltage,
Fig. 6B shows the slope of a path voltage,
Fig. 7 shows a flowchart of the diagnostic process according to the second embodiment.
Fig. 8 shows a flowchart of the diagnostic process according to the third embodiment,
Fig. 9 shows a timing chart when the main relay is normal,
Fig. 10 shows a timing chart when the main relay is in the on-failure state,
Fig. 11A shows an approximate straight-line,
Fig. 11B shows the approximate straight-line,
Fig. 11C shows the approximate straight-line,
Fig. 12 shows a diagram of the control system according to the fourth embodiment,
Fig. 13 shows a flowchart of the diagnostic process according to the fourth embodiment,
Fig. 14 shows a flowchart of the diagnostic process according to the fourth embodiment,
Fig. 15 shows a flowchart of the diagnostic process according to anther embodiments.

[DESCEIPTION OF EMBODIMENTS]

The following first to third embodiments are not according to the invention and are present for illustration purposes only.

<First embodiment>

The following is a description, with reference to the drawings, of the first embodiment of the diagnostic device of the present disclosure applied to an in-vehicle control system 10.

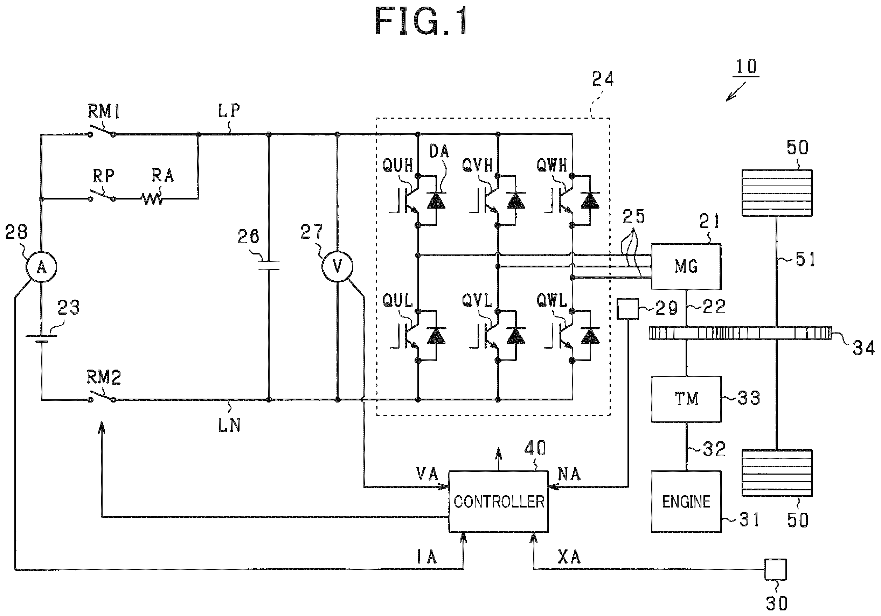

As shown in figure 1, control system 10 is a control system for a hybrid vehicle having an engine 31 and a motor 21 as a driving power source. The control system 10 is an example of a power system. An output shaft 32 of the engine 31 is connected to a rotating shaft 22 of the motor 21 through a transmission 33. The rotating shaft 22 of the motor 21 is connected via a gear mechanism 34 to an axle 51 that connects the left and right wheels 50 in the vehicle. Through the gear mechanism 34, the driving power of the engine 31 and the motor 21 is transmitted to the wheels 50, causing the wheels 50 to rotate. The rotation of the wheels 50 also rotates the motor 21, and the motor 21 generates electric power. The electric power generated by the motor 21 is stored in a battery 23, which is a power source.

The battery 23 is connected to the motor 21 via an inverter 24 and supplies power to or obtains power from the motor 21. For example, the battery 23 may be a lithium-ion storage battery. The motor 21 is a 3-phase synchronous motor and has U, V, and W phase windings as stator windings. The motor 21 may be, for example, a permanent magnet synchronous motor.

The inverter 24 has a series connection of upper arm switches QUH, QVH, QWH and lower arm switches QUL, QVL, QWL with respect to each of the three phases. In the first embodiment, voltage-controlled semiconductor switching devices are used as each switch. For example, the semiconductor switching devices may be IGBTs. A freewheel diode DA is connected to each switch in reverse parallel.

In each series connection, the connection point between a low potential side terminals of the upper arm switches QUH, QVH, and QWH and a high potential side terminals of the lower arm switches QUL, QVL, and QWL is connected to the corresponding winding of the motor 21 via a conductive member 25 such as a bus bar. The high potential side terminals of each upper arm switch QUL, QVH, QWH are connected to the positive terminal of the battery 23 by the positive side power supply path LP. The low potential side terminals of each lower arm switch QUL, QVL, and QWL are connected to the negative terminal of the battery 23 by the negative power supply path LN.

The control system 10 has a smoothing capacitor 26. The smoothing capacitor 26 is connected between the positive power supply path LP and the negative power supply path LN and is connected in parallel to the battery 23.

The control system 10 has a first main relay RM1 and a second main relay RM2 as power switches. The first main relay RM1 is provided on the side of the battery 23 than the smoothing capacitor 26 in the positive side power supply path LP. The second main relay RM2 is provided on the battery 23 side than the smoothing capacitor 26 in the negative pole side power supply path LN. Each of the first main relay RM1 and the second main relay RM2 switches the power supply state of the battery 23 and the motor 21 between a conduction state and a shutdown state.

A series connection of a pre-charge relay RP and a resistive element RA is connected in parallel to the first main relay RM1. When the pre-charge relay RP is turned on (closed) at the start of conduction between the battery 23 and the motor 21, conduction through a resistive element RA suppresses the inrush current flow between the battery 23 and the motor 21. The pre-charge relay RP and the resistive element RA may be provided on the negative pole side instead of the positive pole side, or the pre-charge relay RP and the resistive element RA may not be provided on either the positive pole side or the negative pole side. In the first embodiment, mechanical relay switches are used as each relay RM1, RM2, and RP.

The control system 10 has a voltage sensor 27, a current sensor 28, a revolution sensor 29, and a vehicle speed sensor 30. The voltage sensor 27 is connected between the positive power supply path LP and the negative power supply path LN on the inverter 24 side than the main relays RM1 and RM2. The voltage sensor 27 detects voltage between the positive power supply path LP and the negative power supply path LN as a voltage VA, which is the voltage between the positive pole side power supply path LP and the negative pole side power supply path LN, i.e., the voltage applied to the smoothing capacitor 26. The revolution sensor 29 detects the number of revolutions per unit time of the motor 21, i.e., the number of revolutions NA per unit time. The vehicle speed sensor 30 detects the rotational speed of the wheels 50, i.e., vehicle speed XA, which is the traveling speed of the vehicle. The detected values of each of the sensors are input to the control unit 40 of the control system 10.

The functions provided by the control unit 40 as a diagnostic device can be provided by software recorded in a substantive memory device and a computer executing the software, software only, hardware only, or a combination thereof. for example, if the control unit 40 is provided by an electronic circuit that is hardware, it can be provided by a digital or analog circuit that includes some logic circuits. for example, the control unit 40 executes a program stored in a non-transitory substantive recording medium (non-transitory tangible storage medium) as its own storage unit. When the program is executed, the method corresponding to the program is performed. The memory is, for example, a nonvolatile memory. The program stored in the memory may be updated via a network, such as the internet, for example.

The controller 40 acquires each detection value and executes various controls based on the acquired values. Specifically, the controller 40 controls the inverter 24 and controls the open/close state of each relay RM1, RM 2, and RP based on each detected value.

The controller 40 also diagnoses a failure of the main relays RM1 and RM2 when a switch diagnostic condition is satisfied. For example, if an abnormality occurs in the battery 23 or the inverter 24 while the vehicle is running, which causes an overcurrent to flow in power supply paths LP and LP, the failure of main relays RM1 and RM2 is diagnosed.

In the first embodiment, when it is determined that an abnormality (hereinafter referred to as "specified abnormality") has occurred in the devices connected to the main relays RM1 and RM2, such as battery 23 and inverter 24, in the closed (conducting) state of the main relays RM1 and RM2, the switch diagnosis condition is deemed to be satisfied, a shutdown command is output to shut down the main relays RM1 and RM2 with the control of the inverter 24 stopped. In addition, the voltage change δv, which is the difference of the path voltage VA according to the change in the number of revolutions NA of motor 21 that occurs after the output of the shutdown command, for example, in the situation where the change in the number of revolutions NA of motor 21 occurs after the output of the shutdown command, the voltage change $\delta v$ of the path voltage VA before and after the change in number of revolutions NA is acquired, and the on-failure state of the main relays RM1 and RM2 is diagnosed based on the voltage change $\delta v$.

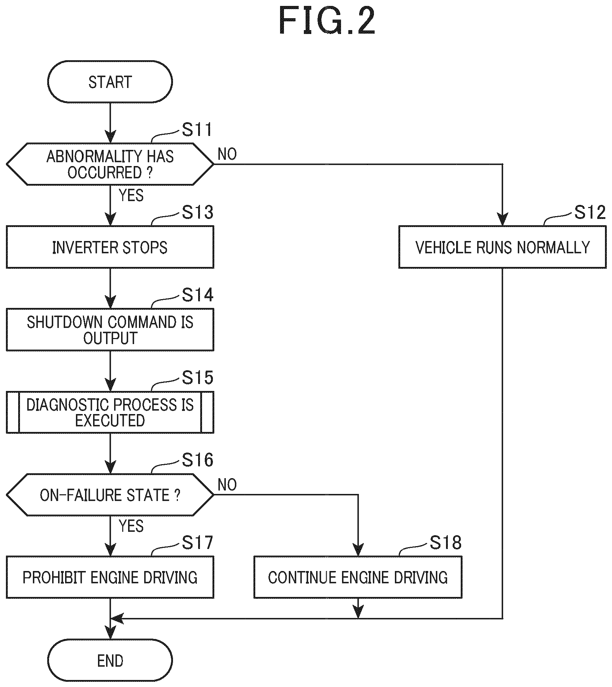

Figure 2 shows a flowchart of the control procedure according to the first embodiment. The controller 40 repeatedly executes the control procedure in a predetermined cycle while the vehicle is running.

After starting the control process, in step 11, the controller 40 determines whether a specified abnormality has occurred. The controller 40 may determine whether the specified abnormality has occurred based on the detected value of the current sensor 28, for example. When the specified abnormality has not occurred, the controller 40 proceeds to step 12 and the vehicle runs normally. Normal driving is driving of the vehicle by the driving force of at least one of the engine 31 and the motor 21. On the other hand, when the specified abnormality has occurred, the controller 40 proceeds to step 13.

In step 13, the control of inverter 24 is stopped to shut down main relays RM1 and RM2 with the current flowing in main relays RM1 and RM2 set to zero. In the subsequent step 14, the shutdown command to shut down main relays RM1 and RM2 is output. In the vehicle, as the inverter control is stopped, driving by the motor 21 is prohibited and driving by the engine drive power is performed. In the first embodiment, the process of step 14 is an example of a "shutdown command unit" or, "shutdown command step".

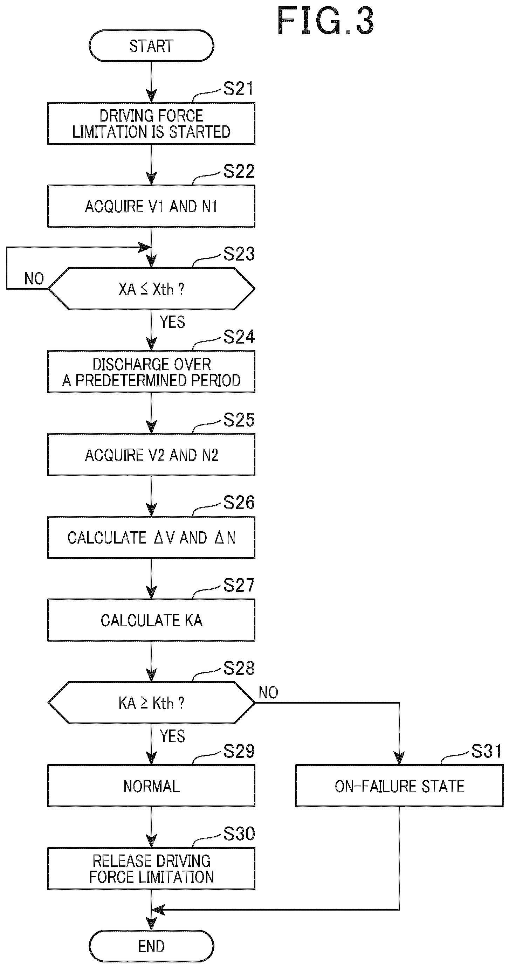

In step 15, a diagnostic process is executed to determine whether the main relays RM1 and RM2 are in the on-failure state. Figure 3 shows the procedure of the diagnostic process.

In step 21, the driving force of engine 31 is reduced. This reduction of the engine driving force causes the vehicle speed XA to decrease and the number of revolutions NA of the motor 21 to decrease. When starting to limit the driving force of the engine 31, it is preferable to inform the driver about the limiting the driving force to avoid causing discomfort to the driver due to the vehicle deceleration.

In step 22, the path voltage (detection voltage) VA and the number of revolutions NA are acquired. In step 22, the path voltage VA and the number of revolutions NA are acquired after the path voltage VA becomes stable after the output of the shutdown command. Hereafter, the path voltage VA and number of revolutions NA acquired in step 22 are referred to as the first voltage V1 and the first number of revolutions N1.

In step 23, the vehicle speed XA is acquired, and it is determined whether the vehicle speed XA is less than or equal to the predetermined speed Xth. The predetermined speed Xth is the vehicle speed at which the smoothing capacitor 26 can be discharged by the motor 21 while the motor 21 is rotating. In the discharge of the smoothing capacitor 26 by the motor 21, the inverter 24 is controlled to energize the motor 21 from the smoothing capacitor 26 at a phase where no torque is generated in the motor 21 even if the motor 21 is energized. The predetermined speed Xth is set to a predetermined number of revolutions Nth. The predetermined number of revolutions Nth is a maximum value that can suppress the generation of vibration, etc. of the motor 21 caused by the back EMF of the motor 21 and reduce the path voltage VA even if the smoothing capacitor 26 is discharged by the motor 21 while the motor 21 is rotating. When the vehicle speed XA is greater than the predetermined speed Xth, step 23 is repeated.

When the vehicle speed XA is less than the predetermined speed Xth, the controller 40 proceed to step 24 to discharge the smoothing capacitor 26 over a predetermined period while the motor 21 is rotating. At this time, the smoothing capacitor 26 is discharged over a period longer than the period required for the path voltage VA to decrease to the electromotive force voltage due to the back EMF of the motor 21 (hereinafter referred to as "back EMF voltage"). This discharge causes the path voltage VA to decrease below the back EMF voltage of the motor 21. In the first embodiment, the process in step 24 is an example of a "discharge processing unit.

In step 25, the path voltage VA and the number of revolutions NA are acquired after the smoothing capacitor 26 is discharged. In this case, the path voltage VA is acquired when the transient voltage change converged. In step 25, a second voltage V2 and a second number of revolutions N2 are acquired at the timing when the difference between the first number of revolutions N1 and the second number of revolutions N2 exceeds a predetermined change. Hereafter, the path voltage VA and the number of revolutions NA acquired in step 25 are referred to as the second voltage V2 and second number of revolutions N2.

In step 26, the difference between the first number of revolutions Na and the second number of revolutions N2 is calculated as the change in the number of revolutions NA, $\delta n$. In step 26, the difference between the first voltage V1 and the second voltage V2 is calculated as the voltage change $\delta v$ of the path voltage VA before and after the above change amount $\delta n$. The first voltage V1 is the path voltage VA before the discharge of the smoothing capacitor 26, and the second voltage V2 is the path voltage VA after the discharge of the smoothing capacitor 26. Therefore, the voltage change $\delta v$ can be referred to as the voltage change in the path voltage VA before and after the discharge of the smoothing capacitor 26. In the first embodiment, the processes of steps 22, 25, and 26 are examples of "acquisition unit" or "acquisition steps".

In step 27, a slope KA of the change in path voltage VA before and after the change in number of revolutions NA is calculated. The slope KA is the ratio of the voltage change $\delta v$ of path voltage VA to the change $\delta n$ of the number of revolutions NA and is expressed using each of the detected values V1, V2, N1, N2 as in (equation 1) below.

$$KA= \delta v/\delta n = (V2\text{-}V1) / (N2\text{-}N1) \ldots (\text{equation } 1)$$

In step 28, it is determined whether the slope KA calculated in step 27 is greater than or equal to the predetermined slope threshold Kth. when the slope KA is greater than or equal to the slope threshold Kth, the controller 40 proceeds to step 29 to diagnose that the main relays RM1 and RM2 are normal. In this case, in step 30, the limitation of the driving force of the engine 31 is lifted to release the reduced state of vehicle speed XA, and this process is temporarily terminated. In the first embodiment, the process of step 28 is an example of a "diagnosis unit" or diagnosis step," and the process of steps 21 and 30 are an example of a "speed control unit".

When the slope KA is less than the slope threshold Kth, the controller 40 proceeds to step 31 to diagnose that the main relays RM1 and RM2 are in the on-failure state. In this case, this process is temporarily terminated with the engine 31 drive power limitation maintained.

Returning to figure 2, in step 16, the controller 40 determines whether the main relays RM1 and RM2 are diagnosed as being in the on-failure state in the diagnostic process of step 15. When the main relays RM1 and RM2 are diagnosed as being in the on-failure state, the controller 40 proceeds to step 17 to prohibit the engine 31 from driving and terminate this iteration of the process. When the main relays RM1 and RM2 are diagnosed as normal, the controller 40 proceeds to step 18 to continue vehicle driving by engine 31 and terminate this iteration of the process. In the first embodiment, the diagnostic process is executed on the condition that a specific abnormality has occurred, and even if the main relays RM1 and RM2 are diagnosed as normal in step 16, the prohibition of driving by the motor 21 is maintained.

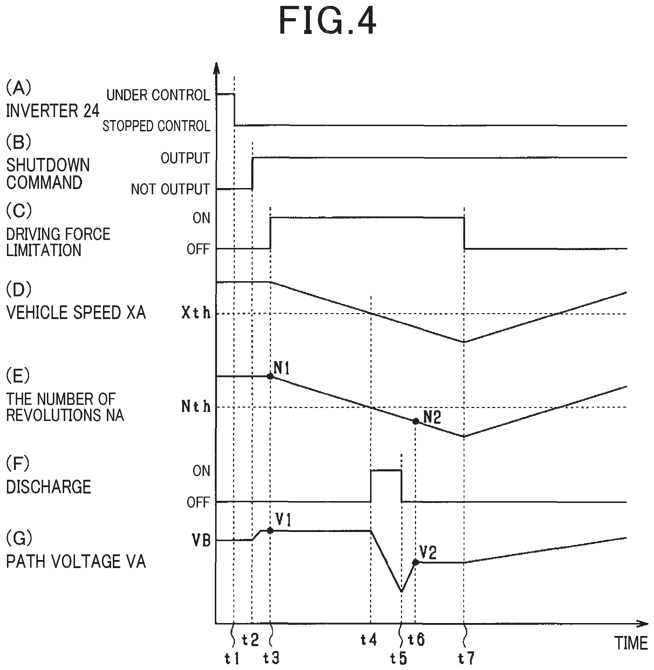

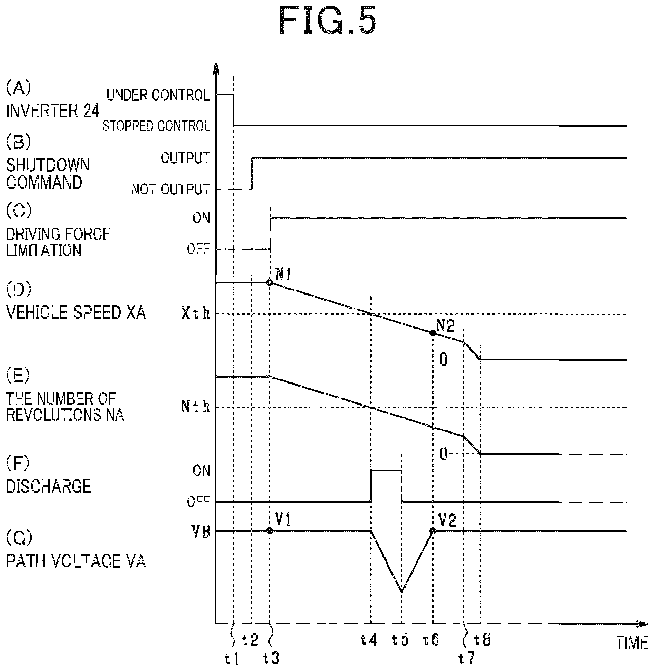

Figures 4 and 5 are then used to explain the diagnostic procedure. In figures 4 and 5, (A) shows the transition of the control state of inverter 24, (B) shows the transition of the shutdown command of main relays RM1 and RM2, (C) shows the transition of the engine 31 driving force limitation, (D) shows the transition of vehicle speed XA, (E) shows the transition of number of revolutions NA, (F) shows the transition of discharge of smoothing capacitor 26, and (G) shows the transition of path voltage VA.

As shown in figure 4, before time t1, vehicle speed XA is above the predetermined speed Xth. The main relays RM1 and RM2 are closed, and the number of revolutions NA is above the predetermined number of revolutions Nth by the control of inverter 24. Then, at time t1, it is determined that a specific abnormality has occurred, and the control of the inverter 24 is stopped. Then, at time t2, a shutdown command is output to shut down main relays RM1 and RM2. In figure 4, it is assumed that main relays RM1 and RM2 are normal, and the output of the shutdown command opens main relays RM1 and RM2, and path voltage VA changes from the power supply voltage VB of battery 23 to the back EMF voltage.

When the shutdown command is output, the driving force limitation of the engine 31 starts at time t3 to reduce the number of revolutions NA of the motor 21. In the case where a failure in the main relays RM1 and RM2 due to the occurrence of a specific abnormality is a concern, the driving force of the engine 31 is limited to lower the vehicle speed XA, thereby ensuring the driving safety of the vehicle. The first voltage V1 and the first number of revolutions N1 are acquired at time t3. The first voltage V1 is acquired after the path voltage VA becomes stable after the shutdown command output.

. When the driving force of the engine 31 is limited at time t3, the number of revolutions NA decreases as the vehicle speed XA decreases. When the number of revolutions NA decreases, the back EMF voltage decreases, but the smoothing capacitor26 keeps the path voltage VA constant.

When the number of revolutions NA decreases to the predetermined number of revolutions Nth at time t4, the smoothing capacitor 26 is discharged for the predetermined period from time t4 to t5. This causes the path voltage VA to decrease to a voltage lower than the back EMF voltage of the motor 21. When the discharge of the smoothing capacitor 26 is stopped at time t5, the path voltage VA increases due to the back EMF voltage of the motor 21. When the path voltage VA increases to the back EMF voltage of the motor 21 at time t6, the second voltage V2 and the second number of revolutions N2 are acquired. The second voltage V2 is acquired after the path voltage VA becomes stable after the path voltage VA increases to the counter electromotive voltage.

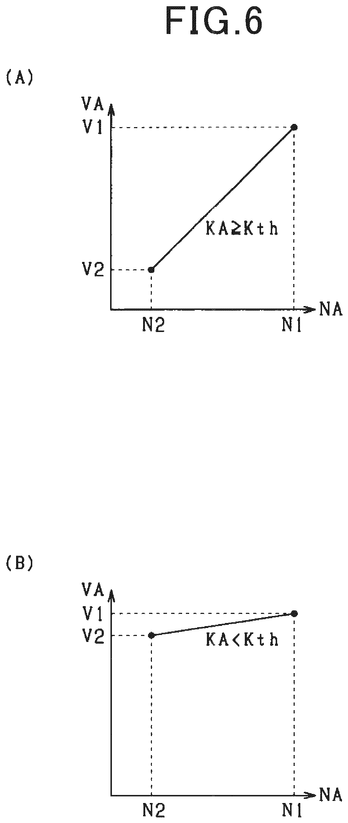

Once the second voltage V2 and the second number of revolutions N2 are acquired, the slope KA of the path voltage VA is calculated using the respective detected values V1, V2, N1, N2. In the example shown in figure 4, the second voltage V2 is lower than the first voltage V1 as the second number of revolutions N2 is lower than the first number of revolutionsN1. Therefore, as shown in figure 6A, the slope KA is greater than the slope threshold Kth. As a result, the main relays RM1 and RM2 are diagnosed as normal, the driving force limitation of the engine 31 is released at time t7, and the vehicle continues to run using the engine 31. As a result, vehicle speed XA increases, and the vehicle returns to driving.

Figure 5 shows the transition of each value when the main relays RM1 and MR2 are diagnosed as being in the on-failure state. In this case, the main relays RM1 and RM2 are kept closed even after the shutdown command is output, and the path voltage VA is maintained at the power supply voltage VB of the battery 23. When the discharge of the smoothing capacitor 26 is stopped at time t6, the path voltage VA increases to the power supply voltage VB. Therefore, in the example shown in fig. 5, the second voltage V2 becomes almost the same value as the first voltage V1, and the slope KA becomes smaller than the slope threshold Kth, as shown in fig. 6B. As a result, it is diagnosed that the main relays RM1 and RM2 are in the on-failure state and driving of the vehicle by the engine 31 is prohibited at time t7 while the driving force limitation of the engine 31 is maintained. Specifically, drive of the engine 31 is stopped at time t7, and driving of the vehicle is stopped at time t8.

According to the first embodiment detailed above, the following effects can be obtained.

In the first embodiment, when an abnormality occurs in the battery 23, the inverter 24, etc. in the closed state of the main relay RM1 and the main relay RM2, the shutdown command is output to shut down the main relay RM1 and the main relay RM2 while the control of inverter 24 is stopped. The voltage change $\delta v$, which is the difference in the path voltage VA according to the change in the number of revolutions NA of the motor 21

that occurs after the output of the shutdown command, is acquired, and based on the voltage change $\delta v$, the failure in the main relays RM1 and RM2 is diagnosed in on-state. This allows the on-failure state of the main relays RM1 and RM2 to be properly diagnosed. In addition, the first embodiment diagnoses the on-failure state of the main relays RM1 and RM2 while the control of the inverter 24 is stopped, which allows for switch failure diagnosis with a simple configuration without causing voltage changes due to inverter control.

In the first embodiment, the smoothing capacitor 26 is made to discharge under the situation where the number of revolutions NA of the motor 21 decreases after the output of the shutdown command. This allows the path voltage VA to be set to a voltage corresponding to the number of revolutions NA of motor 21 after the output of the shutdown command, and the on-failure state of the main relays RM1 and RM2 can be properly diagnosed.

In the first embodiment, the smoothing capacitor 26 is discharged so that the path voltage VA becomes lower than the back EMF voltage of the motor 21 at the end of the discharge of smoothing capacitor 26. Therefore, the voltage change corresponding to the change in the number of revolutions NA of the motor 21 can be properly ascertained, and thus the failure diagnosis of the main relays RM1 and RM2 can be properly performed.

In the first embodiment, the smoothing capacitor 26 is discharged by the motor 21 when the vehicle speed XA is below the predetermined speed Xth. Therefore, even if the smoothing capacitor 26 is discharged by the motor 21 while the motor 21 is rotating, unstable rotation of the motor 21 due to vibration, etc. of the motor 21 caused by the back EMF of the motor 21 can be suppressed, and the vehicle running is controlled.

In the first embodiment, when outputting the shutdown command for the main relays RM1 and RM2, the number of revolutions NA of the motor 21 is reduced by the reduction of the vehicle speed XA due to the limitation of engine drive power. This allows the desired voltage decreasing in the path voltage VA to occur. In addition, when the main relays RM1 and RM2 are diagnosed as normal by the diagnostic process, the driving force limit of the engine 31 is released to release the reduced state of vehicle speed XA, so that the vehicle's traveling speed can be properly controlled each time depending on whether the main relays RM1 and RM2 are normal or in the on-failure state. Therefore, the vehicle speed can be properly controlled each time depending on whether the main relays RM1 and RM2 are normal or in the on-failure state. Specifically, when the main relays RM1 and RM2 are normal, the driving force limitation of the engine 31 is released, allowing the vehicle to return to driving properly. When the main relays RM1 and RM2 are in the on-failure state, the driving force limitation of the engine 31 is maintained, allowing the vehicle to stop safely.

<Second embodiment>.

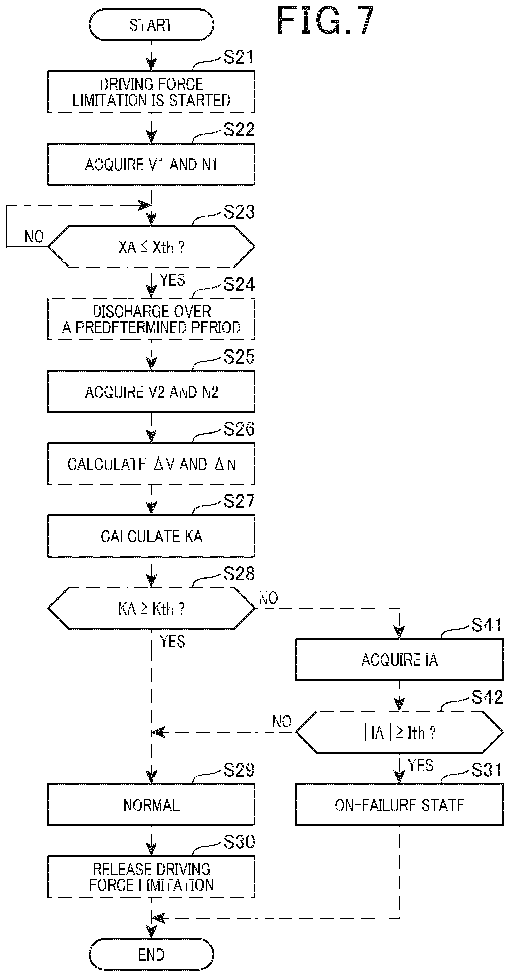

The second embodiment is explained below with reference to figure 7, focusing on the differences from the first embodiment. The second embodiment differs from the first embodiment in that the on-failure state of the main relays RM1 and RM2 is diagnosed based on the power supply current IA in addition to the slope KA of the path voltage VA during the diagnostic process.

Figure 7 shows a flowchart of the diagnostic process in the second embodiment. in figure 7, explanations of the same processes as those shown in the previous figure 3 are omitted for convenience, with the same step numbers.

In the diagnostic process according to the second embodiment, the slope KA of the path voltage VA (ratio of the voltage change $\delta v$ of the path voltage VA to the change $\delta n$ of the number of revolutions NA) is first calculated in steps 21 to 28, and whether the slope KA is greater than or equal to the slope threshold Kth is determined. When a positive determination is made in step 28, the controller 40 proceeds to step 29 to diagnose that the main relays RM1 and RM2 are normal.

When a negative determination is made in step28, the controller 40 proceeds to step41 to acquire the power supply current (detected current) IA. At this time, the power supply current IA after the output of the shutdown command is acquired. In the subsequent step42, it is determined whether the absolute value of the power supply current IA acquired in step41 is equal to or greater than the predetermined current value Ith. When the absolute value of the power supply current IA is less than the predetermined current value Ith, the controller 40 proceeds to step29 to diagnose that the main relays RM1 and RM2 are normal. When the absolute value of the power supply current IA is greater than or equal to the predetermined current value Ith, the controller 40 proceeds to step31 to diagnose that the main relays RM1 and RM2 are in the on-failure state. The process in step28 is an example of a "first determination process" and the process in step42 is an example of a "second determination process. The slope threshold Kth is an example of a "voltage threshold" and the predetermined current value Ith is an example of a "current threshold".

. According to the second embodiment described in detail above, the determination using the slope KA and the determination using the power supply current IA are performed, and when the slope KA is determined to be less than the slope threshold Kth and the power supply current IA is determined to be greater than the predetermined current value Ith, the main relays RM1 and RM2 are diagnosed as being in the on-failure state in this case, the main relays RM1 and RM2 failure is diagnosed as being in on-state. By diagnosing the on-failure state of the main relays RM1 and RM2 using the slope KA and the power supply current IA, the incorrect diagnosis of on-failure state of the main relays RM1 and RM2 can be suppressed compared to the case where the on-failure state is diagnosed using only the slope KA. This method can properly diagnose the on-failure state of the main relays RM1 and RM2 by suppressing incorrect diagnosis of the on-failure state compared to diagnosing the on-failure state of the main relays RM1 and RM2 by using only the slope KA.

<Third embodiment>.

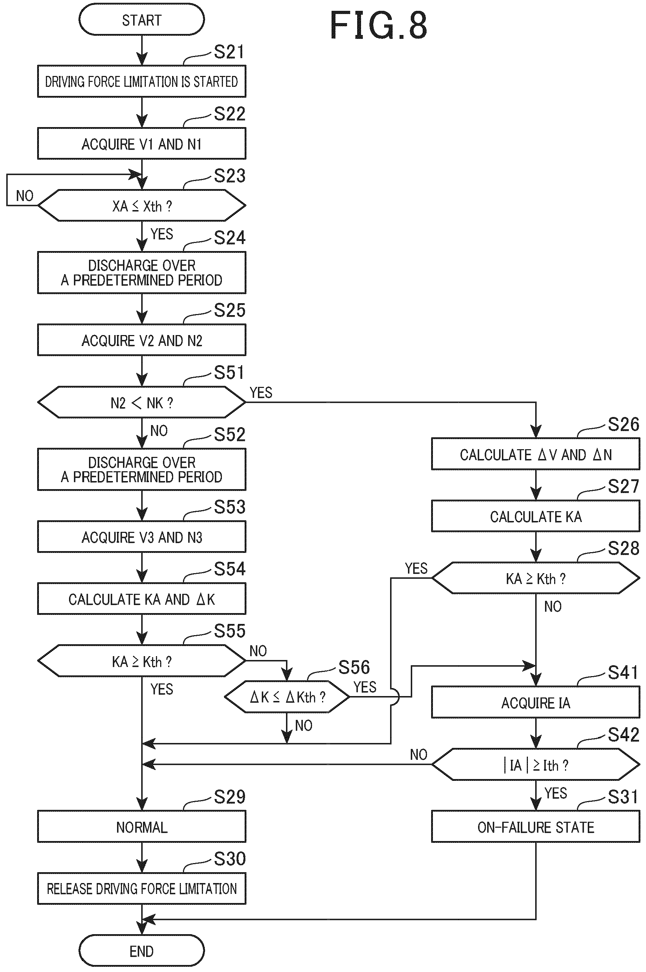

The third embodiment is explained below with reference to figures 8 through 11, focusing on the differences from the second embodiment. In the third embodiment, as a difference from the second embodiment, two capacitors discharge in the diagnostic process, and the combination of the path voltage VA and the number of revolutions NA is acquired three times in accordance with the capacitors discharging. Then, using the three acquired combinations of the path voltage VA and the number of revolutions NA, an approximate straight-line LK that is a linear approximation of the relationship between the path voltage VA and the number of revolutions NA is calculated, and the on-failure state of the main relays RM1 and RM2 is diagnosed based on the slope of the approximate straight-line LK and the scatter of the path voltage VA relative to the approximate straight-line LK.

Figure 8 shows a flowchart of the diagnostic process in the third embodiment. in figure 8, explanations of the same processes as those shown in the previous figure 7 are omitted for convenience, with the same step numbers.

In the diagnostic process according to the third embodiment, after acquiring the second voltage V2 and the second number of revolutions N2 in step25, the controller 40 proceeds to step51 to determine whether the second number of revolutions N2 acquired in step25 is sufficiently small. Specifically, it is determined whether the second number of revolutions N2 is smaller than the reference number of revolutions NK. The reference number of revolutions NK is set to a number lower than the predetermined number of revolutions Nth used to determine whether to discharge the smoothing capacitor 26 in the first discharge of the smoothing capacitor 26. When the second number of revolutions N2 is less than the reference number of revolutions NK, the controller 40 proceeds to step26. In other words, the slope KA of the path voltage VA is calculated by the combination of the first voltage V1, the first number of revolutions N1, the second voltage V2, and the second number of revolutions N2, and the on-failure state of the main relays RM1, RM2 is diagnosed. The combination of the first voltage V1 and the first number of revolutions N1 is an example of "first data" and the combination of the second voltage V2 and the second number of revolutions N2 is an example of "second data".

When the second number of revolutions N2 is greater than the reference number of revolutions NK, the controller 40 proceeds to step52, and after waiting for the number of revolutions NA of the motor 21 to decrease by more than a predetermined value from the second number of revolutions N2, makes the smoothing capacitor 26 discharge during the predetermined period. In other words, the second discharge of the smoothing capacitor 26 is performed. In the subsequent step53, the path voltage VA and the number of revolutions NA are acquired after the path voltage VA becomes stable after discharging the smoothing capacitor 26 in step52. Hereafter, the path voltage VA and the number of revolutions NA acquired in step53 are referred to as the third voltage V3 and the third number of revolutions N3. The combination of the third voltage V3 and the third number of revolutions N3 is an example of "third data".

In step54, the slope KA and scatter δk of the path voltage VA are calculated using each detected value V1, V2, V3, N1, N2, N3. Specifically, the approximate straight-line LK, which is a linear approximation of the relationship between the path voltage V1 to v3 and the number of revolutions N1 to N3, is calculated, and the slope of the approximate straight-line LK is calculated as the slope KA of path voltage VA. The approximate straight-line LK is calculated, for example, by the least-squares method. The scatter of path voltage V1 to v3 with respect to the approximate straight-line LK is calculated as the scatter δk. The scatter δk of path voltagev1 to v3 with respect to approximate straight-line LK is, for example, the total amount of voltage shift (voltage change) of each of the path voltage V1 to V3 with respect to approximate straight-line LK.

In step55, it is determined whether the slope KA calculated in step54 is greater than or equal to the slope threshold Kth. When the slope KA is greater than or equal to the slope threshold Kth, the controller 40 proceeds to step29 to diagnose that the main relays RM1 and RM2 are normal. When the slope KA is less than the slope threshold kth, the controller 40 proceeds to step56.

In step56, it is determined whether the scatter δk calculated in step 54 is less than or equal to the predetermined scatter threshold δkth. When the scatter δk is greater than the scatter threshold δkth, the reliability of the slope KA calculated in step 54 is low and the accuracy of the determination result of step 55 is low, so the controller 40 proceeds to step 29 to determine that the main relays RM1 and RM2 are normal. When the scatter δk is less than the scatter threshold δkth, the reliability of the slope KA calculated in step 54 is high and the judgment accuracy of the determination result of step 55 is high. Therefore, the controller 40 proceeds to step 41.

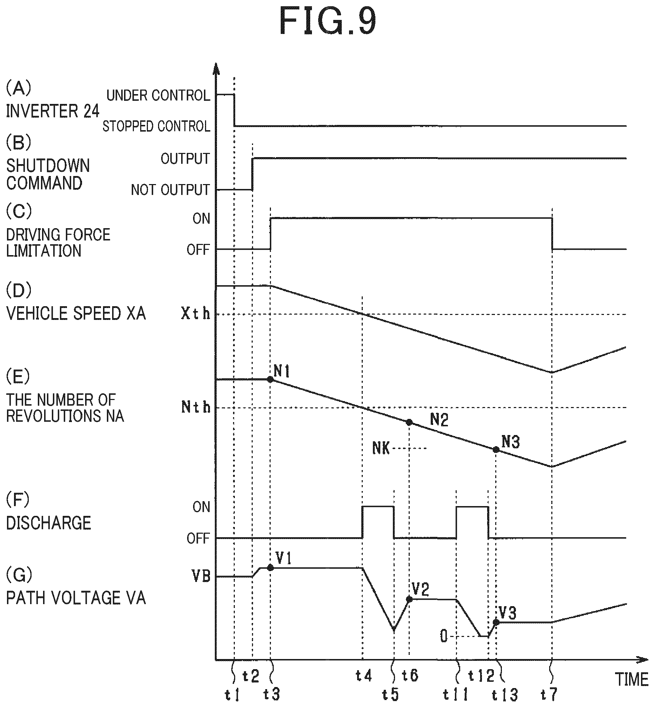

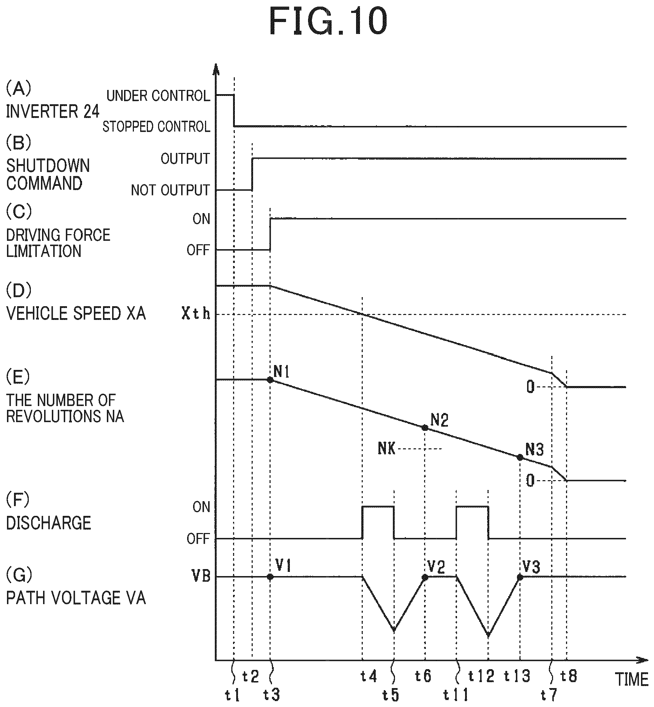

Figures 9 and 10 are then used to explain the diagnostic process. (A) through (G) in figures 9 and 10 are identical to (A) through (G) in figures 4 and 5. In figures 9 and 10, the process from time t1 to t6 is the same as in figures 4 and 5. The duplicated explanations are omitted.

In figure 9, it is assumed that the main relays RM1 and RM2 are normal, and when the second voltage V2 and the second number of revolutions N2 are acquired at time t6, and whether the second number of revolutions N2 is greater than the reference number of revolutions NK is determined. In the example shown in fig. 9, the second number of revolutions N2 is larger than the reference number of revolutions NK. Therefore, when the number of revolutions NA of the motor 21 decreases for the predetermined value from the second number of revolutions N2 at time t11, the smoothing capacitor 26 is discharged for the predetermined period from time t11 to t12. When the discharge of the smoothing capacitor 26 is stopped at time t12 and the path voltage VA increases to the back EMF voltage of the motor 21 at time t13, the third voltage V3 and the third number of revolutions N3 are acquired.

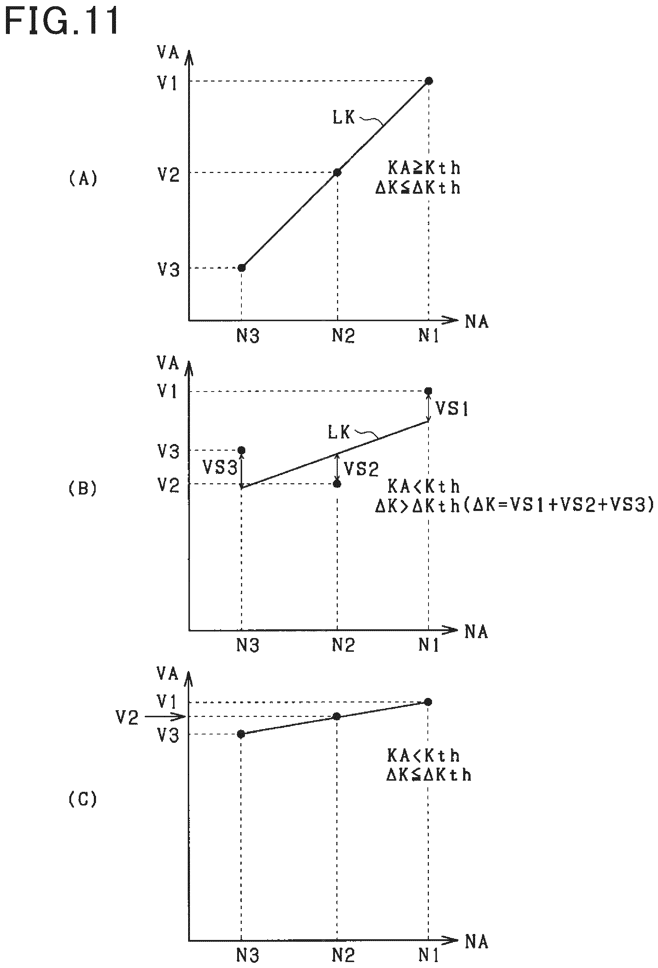

After the third voltage V3 and the third number of revolutions N3 are acquired, the slope KA and the scatter δk of the path voltage VA are calculated using each detected value V1, V2, V3, N1, N2, N3. In figure 9, the path voltage V1 to V3 decreases as the number of revolutions N1 to N3 decreases. Therefore, as shown in figure 11A, the slope KA is above the slope threshold Kth. In addition, the three combinations of the path voltage VA and the number of revolutions NA are located near the approximate straight-line LK, and the scatter δk with respect to the approximate straight-line LK is less than the scatter threshold δkth. Therefore, based on the slope KA and scatter δk of path voltage VA, the main relays RM1 and RM2 are diagnosed as normal.

Even if the main relays RM1 and RM2 are normal, the path voltage VA may change due to detection errors or noise from the voltage sensor 27, for example, the third voltage V3 may be a larger voltage value than the second voltage V2. In this case, as shown in figure 11B, the slope KA becomes less than the slope threshold Kth. On the other hand, the three combinations of the path voltage VA and the number of revolutions NA are deviated from the approximate straight-line LK. The scatter δk is calculated as the sum of voltage deviations. The voltage deviations include the voltage deviation of the first voltage V1 from the approximate straight-line LK VS1, the voltage deviation of the second voltage V2 from the approximate straight-line LK VS2, the voltage deviation of the third voltage V3 from the approximate straight-line LK VS3.Then the scatter δkis larger than the scatter threshold value δkth. In other words, even if the slope KA is less than the slope threshold Kth, the main relays RM1 and RM2 are diagnosed as normal because the reliability of the slope KA is low. This allows proper diagnosis of the on-failure state of the main relays RM1 and RM2 by suppressing incorrect diagnosis of the on-failure state.

Figure 10 shows the transition of each value when the main relays RM1 and RM2 are in the on-failure state. In this case, when the discharge of the smoothing capacitor 26 is stopped at time t12, the path voltage VA increases to the power supply voltage VB, and the third voltage V3 is approximately the same value as the first voltage V1 and the second voltage V2. Therefore, as shown in figure 11C, the slope KA becomes less than the slope threshold Kth. In addition, the three combinations of path voltage VA and number of revolutions NA are located near the approximate straight-line LK, and the scatter δk with respect to the approximate straight-line LK is less than the scatter threshold δkth. Therefore, based on the slope KA and the scatter δk of the path voltage VA, it is diagnosed that the main relays RM1 and RM2 are in the on-failure state.

According to the third embodiment detailed above, the following effects can be obtained.

In the third embodiment, under the situation where a decrease in the number of revolutions NA of the motor 21 occurs after the output of the shutdown command of the main relays RM1 and RM2, the smoothing capacitor 26 is discharged multiple times, and the number of the approximate straight-line LK is calculated from the number of revolutions NA and path voltage VA acquired for each capacitor discharge. Based on the slope KA of the approximate straight-line LK and the scatter δk of the path voltage VA with respect to the approximate straight-line LK, the on-failure state of the main relays RM1 and RM2 is diagnosed. In this case, the reliability of the slope KA of the approximate straight-line LK can be determined based on the scatter δk, and the on-failure state of the main relays RM1 and RM2 can be properly performed by suppressing incorrect diagnosis of the on-failure state of the main relays RM1 and RM2.

In a case that multiple discharges of the 26 smoothing capacitors are performed and the on-failure state of the main relays RM1, RM2 is diagnosed based on the approximate straight-line LK calculated from the number of revolutions NA and the path voltage VA for each capacitor discharge and the scatter δk of the path voltage VA relative to the approximate straight-line LK, it is possible to improve the accuracy of the failure diagnosis, but there is concern that multiple capacitor discharges may be required, which may result in time-consuming failure diagnosis. In addition, when the motor 21 is in a low rpm state, the number of revolutions change from that point may not be expected.

For this regard, in the third embodiment, the following process is applicable. When the second number of revolutions N2 acquired after the first capacitor discharge is higher than the reference number of revolutions NK, the on-failure state of the main relays RM1, RM2 is diagnosed based on the three combinations of the number of revolutions NA and the path voltage VA, and when the second number of revolutions N2 is lower than the reference number of revolutions NK, the first voltage V1 and the first number of revolutions N1 and the second voltage V2 and the second number of revolutions N2 are used to diagnose the on-failure state of the main relays RM1 and RM2. This allows for proper failure diagnosis while considering the rotation state of the motor 21.

<Fourth embodiment>

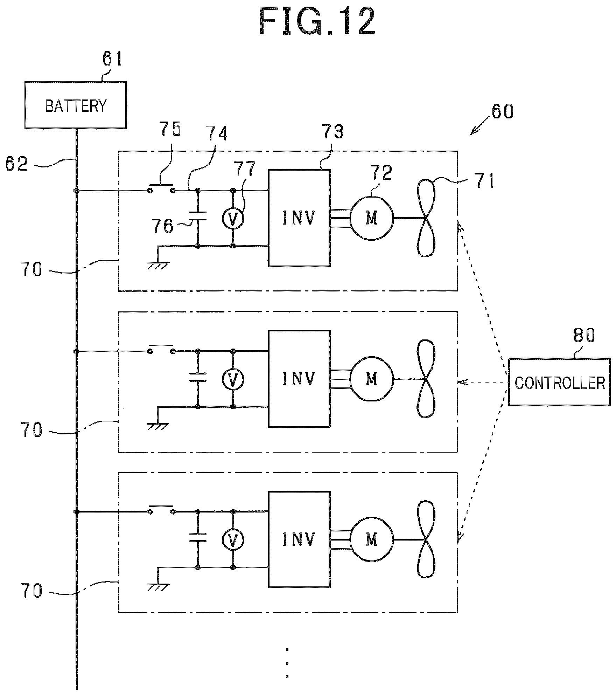

The fourth embodiment describes a power supply system for a propeller-driven electric aerial vehicle. Figure 12 is a schematic diagram of the control system 60 as the power supply system for the aerial vehicle in the fourth embodiment. In figure 12, the control system 60 has a battery 61, a plurality of propeller units 70, and a controller 80. Battery 61 is the power source for the aerial vehicle and supplies power to each propeller unit 70 via power line 62. The aerial vehicle flies due to the rotation of the propellers 71 of each propeller unit 70. in the fourth embodiment, the aerial vehicle is an example of a "mobile object".

The propeller unit 70 has a propeller 71, a motor 72 that rotates the propeller 71, an inverter 73 that adjusts the input and output power of the motor 72, and a power switch 75 on the positive side power supply path 74 that extends from the power line 62. The motor 72 is a motor with multi-phase stator windings, similar to motor 21 described above, and the inverter 73 is a power conversion circuit with multiple switching elements for each phase, similar to inverter 24 described above. The power switch 75 constitutes the main relay and switching the power switch 75 on and off switches the state of conduction between the battery 61 and the inverter 73. In each of the propeller units 70, a smoothing capacitor 76 and a voltage sensor 77 are connected on the inverter 73 side than the power switch 75. The voltage sensor 77 detects the voltage between the positive pole side power supply path 74 as path voltage VA.

In figure 12, the power switch 75 is provided only in the positive path among the positive and negative paths, but the power switch 75 may be provided in both the positive and negative paths. Although not shown in fig. 12, a series connection between a pre-charge relay and a resistor may be connected in parallel to the power switch 75 (see fig. 1).

Although not shown in the figure, each of the propeller units 70 has a current sensor that detects the power supply current flowing in the positive side power supply path 74 and the number of revolutions NA per unit time, or rotational speed, of the motor 72.

Each of the 70 propeller units has a similar configuration and is individually controlled by the controller 80. The controller 80 controls the open/close state of the power switch 75 in each propeller unit 70, controls the rotation of the propeller 71, and so on, as appropriate, based on flight requirements and the detection information from the above sensors.

The aerial vehicle according to the fourth embodiment is capable of both vertical and horizontal flight. For example, the aerial vehicle may move vertically when taking off and landing and move horizontally when moving to the destination. In this case, each propeller unit 70 should be able to be used in different ways depending on the flight situation, and the plurality of propeller units 70 should include propeller unit 70 for vertical flight and propeller unit 70 for horizontal flight. In other words. the propeller unit 70 for vertical flight is a propeller unit 70 for takeoff and landing. However, the propeller unit 70 for vertical flight and the propeller unit 70 for horizontal flight can be driven simultaneously. For example, in the propeller unit 70 for vertical flight, the axis of rotation of the propeller 71 may be oriented to extend in the vertical or abbreviated vertical direction, and in the propeller unit 70 for horizontal flight, the axis of rotation of the propeller 71 may be oriented in the horizontal or abbreviated horizontal direction.

The propeller unit 70 for vertical flight and the propeller unit 70 for horizontal flight may have different maximum outputs. For example, the propeller unit 70 for vertical flight may have a relatively high maximum output, while the propeller unit 70 for horizontal flight may have a relatively low maximum output. However, the reverse may also be true.

The aerial vehicle is capable of flight with the propellers 71 of some of the propeller units 70 of the plurality of propeller units 70 being driven to rotate, and during takeoff and landing and low-speed flight, the aerial vehicle is capable of flight with only the rotation of some of the 71 propellers. When some abnormality occurs in some of the propeller units 70 in the aerial vehicle, it is possible to stop the rotation of the propeller 71 in the propeller unit 70 where the abnormality occurred and fly by rotation of the propeller 71 in the remaining propeller units 70.

The controller 80 also has a function to diagnose a failure of the power switch 75 when the switch diagnostic condition is satisfied. For example, when the rotation of the propeller 71 on some of the propeller units 70 is stopped during flight, in other words, when the rotation of the propeller 71 is no longer required for the propeller units 70 in the drive state, the switch diagnostic condition is assumed to be satisfied for those propeller units 70, and the power switch 75 failure diagnosis is performed.

More specifically, when the aerial vehicle transitions from the takeoff state to the horizontal flight state, the propeller unit 70 for vertical flight is stopped from the driven state. At this time, it may be assumed that the switch diagnosis condition is satisfied for the propeller unit 70 for vertical flight, and the propeller unit 70 for vertical flight is targeted for failure diagnosis. Alternatively, when the aerial vehicle transitions from the horizontal flight state to the landing state, the propeller unit 70 for horizontal flight is stopped from the drive state. At this time, it is recommended to assume that the switch diagnosis condition is satisfied for the propeller unit 70 for horizontal flight and the propeller unit 70 for horizontal flight is targeted for diagnosis. In addition, when reducing the flight speed of an aerial vehicle, some of the propeller units 70 out of the multiple propeller units 70 in drive are stopped. In this case, it is recommended that the switch diagnosis condition is satisfied for the propeller units 70 to be stopped, but the propeller units 70 to be stopped are targeted for failure diagnosis. Not only one propeller unit 70 may be targeted for diagnosis, and two or more propeller units 70 may be targeted for diagnosis at the same time.

It is also possible to perform a failure diagnosis of the power switch 75 by assuming that the switch diagnosis condition is satisfied when an overcurrent flows in the positive pole side power supply path 74 due to an inverter 73 error or the like in each of the 70 propeller units.

In the fourth embodiment, when the switch diagnosis condition is satisfied in the closed state (conduction state) of the power switch 75, a shutdown command is output to shut down the power switch 75 with the control of the inverter 73 stopped. In the situation where the number of revolutions NA of the motor 72 changes after the output of the shutdown command, the voltage change δv of the path voltage VA before and after the change in the number of revolutions NA is acquired, and based on the voltage change δv, the power switch 75 is diagnosed as to whether it is in the on-failure state based on the voltage change δv.

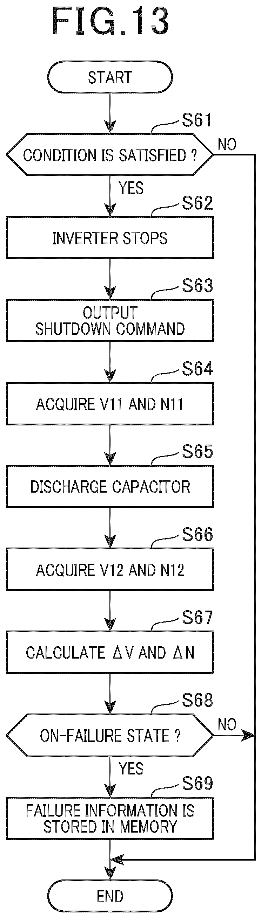

Figure 13 shows a flowchart of the control process according to the fourth embodiment. The controller 80 repeats this control process for each propeller unit 70 in a predetermined cycle during the flight of the aerial vehicle.

After starting the control process, in step 61, the controller 80 determines whether the diagnostic conditions have been satisfied for the propeller unit 70 to be diagnosed this time, and when the diagnostic conditions have been satisfied, the controller proceeds to the subsequent step 62. In step 62, control of the inverter 73 is stopped. As a result, the power drive of the propeller 71 by the motor 72 is stopped, and the number of revolutions of the propeller 71 begins to gradually decrease, as well as the number of revolutions of the motor 72. At this time, the rotational speed of the propeller 71 gradually decreases due to an inertial force. Alternatively, the propeller 71 may coast due to effect of the wind received after the power drive is stopped. In the subsequent step 63, a shutdown command is output to shut off the power switch 75.

Then, in step 64, the path voltage (detection voltage) VA is acquired as the first voltage V11 and the number of revolutions NA is acquired as the first number of revolutions N11 in the propeller unit 70. It is recommended that the first voltage V11 and the first number of revolutions N11 be acquired after the path voltage VA becomes stable after the output of the shutdown command.

Then, in step 65, the smoothing capacitor 76 is discharged a predetermined period under the rotating state of the motor 72. The smoothing capacitor 76 is discharged over a longer period than is necessary for the path voltage VA to decrease to the back EMF voltage due to the back EMF of the motor 72. This discharge causes the path voltage VA to decrease below the back EMF voltage of the motor 72. In step 65, capacitor discharge may be performed on the condition that the number of revolutions of the motor 72 is less than a predetermined value. In other words, the capacitor discharge may be performed on condition that the number of revolutions is less than the predetermined voltage at motor 72.

In step 66, the path voltage VA after capacitor discharge is acquired as the second voltage V12 and the number of revolutions NA is acquired as the second number of revolutions N12. The second voltage V12 and the second number of revolutions N12 should be acquired after the transient change in the path voltage VA has converged. In step 67, the difference between the first number of revolutions N11 and the second number of revolutions N12 is calculated as the change in number of revolutions NAδn, and the difference between the first voltage V11 and the second voltage V12 is calculated as the voltage change δv of the path VA.

Then, in step 68, whether the power switch 75 is failure-in- on-state is determined based on the number of revolutions change and voltage change before and after capacitor discharge. When it is determined that the power switch 75 is not in the on-failure state (i.e., the power switch 75 is normal), the process ends as is.

Specifically in step 68, the slope KA of the change in the path voltage VA before and after the change in number of revolutions NA is calculated by the change in number of revolutions NA δn and the change in voltage of path voltage VA δv (ka=δv/δn). The controller 80 determines whether the power switch 75 is in the on-failure state based on the slope KA. When the slope KA is greater than a predetermined value, the power switch 75 is considered to be normal and this process is terminated as is. When the slope KA is less than the predetermined value, the power switch 75 is in the on-failure state, and the controller 80 proceeds to step 69.

In step 69, failure information is stored in memory for the propeller units 70 targeted for diagnosis this time, and then this process is terminated. Thereafter, it is recommended to prohibit the use of the 70 propeller units targeted for diagnosis this time.

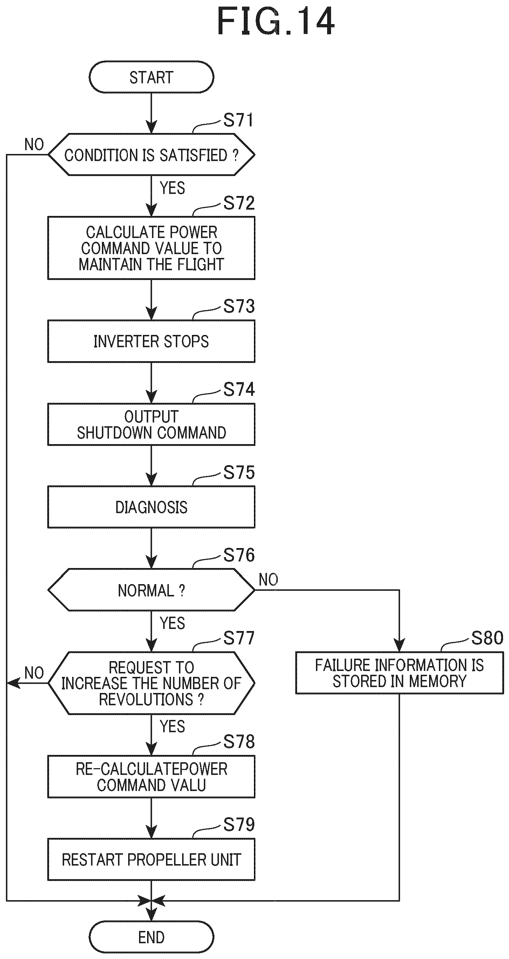

In the fourth embodiment, when some of the propeller units 70 are to be stopped during flight of the aerial vehicle and a shutdown command is output for the propeller units 70 to be stopped, a power command is output to the other propeller units 70 that have not been output to maintain the flight status of the aerial vehicle. In this case, a power command to maintain the flight state of the flying object is output to the other propeller units 70 to which the shutdown command is not output. Specifically, the controller 80 executes the process shown in fig. 14. this process may be rewritten and executed in the process of fig. 13.

In figure 14, in step 71, the controller 80 determines whether the diagnostic condition is satisfied for the propeller units 70 to be diagnosed this time, and when the diagnostic condition is satisfied, the controller 80 proceeds to the subsequent step 72. In step 72, the power command value required to maintain the flight of the aerial vehicle with the propeller units 70 not targeted for diagnosis is calculated, and the power command value is output to the propeller units 70 being driven. In step 73, the control of the inverter 73 is stopped for the propeller unit 70 targeted for diagnosis. As a result, the number of revolutions of propeller decreases in the propeller units 70 to be diagnosed this time, while the flight of the aerial vehicle can be continued by driving the propeller units 70 other than the 70 propeller units to be diagnosed.

In step 74, the shutdown command to shut down the power switch 75 is output, and in subsequent step 75, the diagnosis of the on-failure state of the power switch 75 is performed. At this time, the same process as steps 64 to 68 in figure 13 may be performed.

In step 76, whether the power switch 75 is normal is determined. When the power switch 75 is determined to be normal, the controller 80 proceeds to step 77. In step 77, it is determined whether there is a request to increase the number of revolutions of propeller for the propeller unit 70 targeted for diagnosis. When it is determined that there is a request to increase the number of revolutions of the propeller 71, the controller 80 proceeds to step 78. The controller 80 re-calculates the power command values for each propeller unit 70 when the propeller unit 70 targeted for diagnosis is re-driven, and outputs those power command values to each propeller unit 70. In the subsequent step 79, the propeller units 70 targeted for diagnosis this time are restarted. When it is determined in step 77 that there is no request to increase the number of revolutions of the propeller 70 of the propeller unit 70 targeted for diagnosis this time, the process is terminated as it is.

When the power switch 75 is in the on-failure state and when a negative determination is made in step 76, the controller 80 proceeds to step 80. In step 80, the use of the propeller unit 70 that is being diagnosed this time is prohibited, and then this process is terminated.

According to the fourth embodiment detailed above, the following effects can be obtained.

When the shutdown command of power switch 75 is output in the aerial vehicle, the number of revolutions of the motor 72 decreases along with the decrease in the number of revolutions of the propeller 71, which can cause the desired voltage decreasing required for the failure diagnosis of the power switch 75 on the inverter 73 side.

When the power switch 75 is determined to be normal and there is the request to increase the number of revolutions of the propeller 71, the number of revolutions of the propeller 71 lowered state is released, so that after the power switch 75 failure diagnosis, the flight of the aerial vehicle can be suitably restored to the pre-diagnosis state after the power switch 75 is diagnosed to be in the on-failure state.

When an aerial vehicle with a plurality of propeller units 70 is in flight and some of the propeller units 70 are to be stopped from the drive state, the switch diagnostic condition is determined be satisfied for the propeller units 70 to be stopped, and the shutdown command is output. In this case, the correctness of the diagnostic condition is determined in accordance with the flight condition of the aerial vehicle, for example, when the aerial vehicle transitions from takeoff to horizontal flight, and the shutdown command for the power switch 75 is output. Therefore, failure diagnosis can be performed on the propeller unit 70 in the drive stop state without affecting the flight status of the aerial vehicle.

When some of the propeller units 70 are to be stopped in flight and a shutdown command is output for the propeller units 70 to be stopped, power command values are output to the other propeller units 70 for which shutdown commands have not been output to maintain the aerial vehicle in a moving state. This allows a plurality of propeller units 70 to be used for driving. As a result, when the drive is stopped in any of the plurality of propeller units 70 targeted for diagnosis, the flight status of the aerial vehicle is maintained unchanged before and after the drive is stopped. This allows failure diagnosis of the propeller units 70 to be performed without affecting the flight status of the aerial vehicle.

Although the fourth embodiment assumes an aerial vehicle as the mobile object and the plurality of propeller units 70 as the plurality of drive units, this configuration may be changed. For example, an electric vehicle may be assumed as the mobile object, and a plurality of wheel units may be assumed as the plurality of drive units. The wheel units may be, for example, in-wheel motors with motors integrated into the wheels. in this case, the electric vehicle allows driving by driving some of the wheel units out of all the wheel units. For example, the electric vehicle may have a front side wheel unit and a rear side wheel unit, and the electric vehicle may be able to travel by driving at least one of the front and rear wheel units.

When some of the wheel units among the multiple wheel units in the drive state are to be stopped while the electric vehicle is running, the controller assumes that the switch diagnosis condition is satisfied for the wheel unit to be stopped, and outputs a shutdown command for the power switch. then, the voltage change, which is the difference in the detected voltage according to the change in the number of revolutions of the motor that occurs after the shutdown command is output, is acquired, and the failure in the on-state of the power switch is diagnosed based on the voltage change.

When some of the wheel units are to be stopped while the electric vehicle is running, and when a shutdown command is output for the wheel unit to be stopped, it is recommended that a power command to maintain the running state of the electric vehicle be output for the other wheel units to which the shutdown command has not been output.

<Other embodiment>.

Each of the above embodiments may be implemented with the following modifications.

In the above embodiments, the configuration for diagnosing the on-failure state of the main relays RM1 and RM2 using, for example, the slope KA of path voltage VA is shown. For example, the on-failure state of the main relays RM1 and RM2 may be diagnosed using the voltage change δv of path voltage VA before and after the change in the number of revolutions NA. Specifically, the on-failure state of the main relays RM1 and RM2 may be diagnosed based on whether the voltage change δv of the path voltage VA before and after the change in number of revolutions NA is greater than or equal to the predetermined voltage change threshold δvth. In this case, when the change in number of revolutions NA before and after the change in the number of revolutions NA δn is large, the voltage change threshold δvth may be set larger than when it is small.

In the second embodiment, an example of diagnosing the on-failure state of the main relays RM1 and RM2 based on the slope KA of the path voltage VA and the power supply current IA after the output of the shutdown command is shown, but this is not limited to this example. In addition, the power supply current IA before the output of the shutdown command may be acquired, and the failure in-state of the main relays RM1 and RM2 may be diagnosed using the current change between the power supply current IA before the output of the shutdown command and the power supply current IA after the output of the shutdown command. specifically, when the slope KA of the path voltage VA is less than the slope threshold kth and the absolute value of the power supply current IA after the output of the shutdown command is greater than the predetermined current value Ith, it may be further determined whether the current change of the power supply current IA before and after the output of the shutdown command is greater than the predetermined change threshold. this may be done. if the current change is smaller than the change threshold, it may be diagnosed that the main relays RM1 and RM2 are failing in on-state. if the current change is greater than the change threshold, it may be diagnosed that the main relays RM1 and RM2 are normal.

In the third embodiment, an example of acquiring the combination of the path voltage VA and the number of revolutions NA three times is shown, but the number of times to acquire the combination of the path voltage VA and the number of revolutions NA is not limited to three times but may be four or more times. In this case, when the number of times the combination of path voltage VA and number of revolutions NA is acquired is large, the scatter threshold δkth may be set larger than when it is small.

In the first to third embodiments, the method of limiting the driving force of the engine 31 is exemplified as a method of decreasing the number of revolutions NA of the motor 21 after the output of the discharge command but is not limited to this. For example, the gear mechanism 34 may be configured to change the gear ratio GA of the rotating shaft 22 relative to the axle 51, and when the number of revolutions NA is lowered, the gear ratio GA of the rotating shaft 22 relative to the axle 51 may be increased. In this embodiment, the axle 51 is an example of a "rotation transmission path".

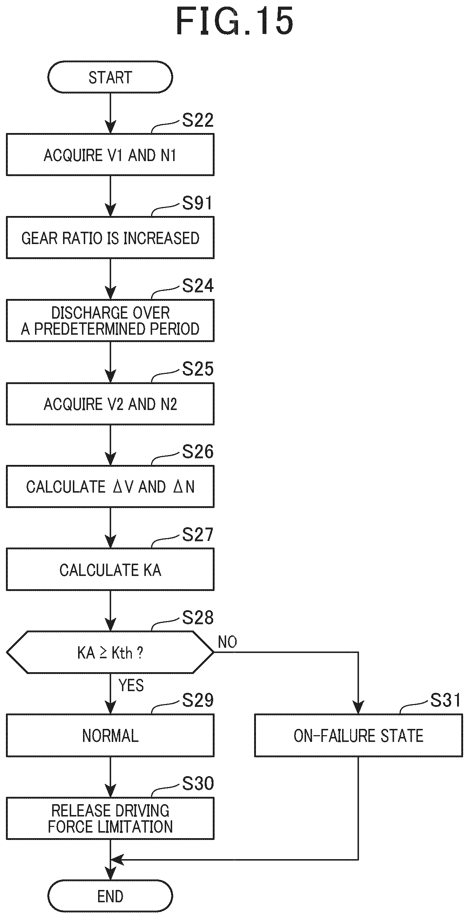

Figure 15 shows a flowchart of the diagnostic process in other embodiments. In figure 15, explanations of the same processes as those shown in the previous figure 3 are omitted for convenience, with the same step numbers.

In this embodiment, the first voltage V1 and the first number of revolutions N1 are acquired in step 22 without limiting the driving force of the engine 31, and then it is proceeded to step 91. In step 91, the gear ratio GA is increased while the vehicle is running after the shutdown command is output. The increase in the gear ratio GA causes the number of revolutions NA of the motor 21 to decrease. In the subsequent step 25, the second voltage V2 and the second number of revolutions N2 are acquired. Therefore, in step 26, the voltage change δv of path voltage VA is calculated before and after the increase in gear ratio GA. In this embodiment, the process of step 91 is an example of a "gear ratio adjustment unit".

In this embodiment, the number of revolutions NA of the motor 21 can be reduced while suppressing the reduction of vehicle speed XA, thus reducing the sense of discomfort caused by deceleration while the vehicle is in motion.

The switch diagnostic condition is not limited to the occurrence of a specific abnormality. For example, in the case of periodic diagnosis of the on-failure state of power switches, the periodic diagnosis condition, such as the elapse of a specified diagnosis cycle, may be regarded as a switch diagnosis condition.

In addition to the occurrence of a specified abnormality, the periodic diagnosis condition may be regarded as the switch diagnosis condition. In this case, if the diagnostic process is executed on the condition that a specified abnormality has occurred, it is preferable to maintain the prohibition of running the vehicle by the motor 21 even if the main relays RM1 and RM2 are diagnosed as normal in step 16 of the diagnostic process. On the other hand, if the diagnostic process is executed on the condition that the periodic diagnostic condition is satisfied, the prohibition of running the vehicle by motor 21 may be lifted when the main relays RM1 and RM2 are diagnosed as being normal in step 16 of the diagnostic process. This allows switching between allowing or disallowing the running of the vehicle using motor 21 depending on the type of switch diagnostic condition.

When the present disclosure is realized as an in-vehicle power supply system, it can be applied to a hybrid vehicle that can be driven independently by the engine 31 and accompanied by the motor 21 and wheels 50. In this case, the connection structure between the engine 31 and the motor 21 in the hybrid vehicle is not limited to the abovementioned embodiment but can be applied to hybrid vehicles with well-known transmission structures.

The diagnostic device and methods described in this disclosure may be realized by a dedicated computer provided by comprising a processor and memory programmed to perform one or more functions embodied in a computer program. Alternatively, the diagnostic apparatus and method described in this disclosure may be realized by a dedicated computer provided by configuring a processor with one or more dedicated hardware logic circuits. Alternatively, the diagnostic apparatus and methods described in this disclosure may be realized by one or more dedicated computers provided by a combination of a processor and memory programmed to perform one or more functions and a processor configured by one or more hardware logic circuits. The computer program may also be stored in a computer-readable non-transitory recording medium as instructions to be executed by a computer.

**Claims**

1. A diagnostic device (80) applicable to a power supply system (60), the power supply system (60) comprising: a power supply (61); an inverter (73) connected to the power supply (61), wherein the inverter (73) is a power conversion circuit with multiple switching elements for each phase;

   a motor (72) connected to the inverter (73); a power switch (75) on a power supply path connecting the power supply (61) and the inverter (73); a voltage sensor (77) that detects a path voltage, the path voltage being a voltage of the power supply path on the inverter side of the power switch (75),
   wherein the diagnostic device (80) comprising:

   a shutdown command unit that is configured to output a shutdown command to shut down the power switch (75) with the control of the inverter (73) stopped when a switch diagnostic condition is satisfied in the conduction state of the power switch (75);
   **characterized by**
   an acquisition unit that is configured to acquire a voltage change, which is the change in the detected voltage of the voltage sensor (77) in response to the change in the number of revolutions of the motor (72) after the output of the shutdown command by the shutdown command unit;
   a diagnostic unit that is configured to diagnose whether the power switch (75) is in an on-failure state based on the voltage change of at least two different time points, wherein
   the path voltage changes in response to the change in the number of revolutions of the motor (72) when the shutdown command is output and the control of the inverter (73) is stopped,
   the power supply system (60) is configured to rotate a propeller (71) by the motor (72) in an aerial vehicle that flies with the rotation of the propeller (71),
   the diagnostic device (80) further comprises a propeller rotation control unit, that is configured, when the shutdown command is output by the shutdown command unit, to reduce the number of revolutions of the motor (72) along with the number of revolutions of the propeller (71), and
   the propeller rotation control unit is further configured to, after the shutdown command is output and the diagnostic unit diagnosed, when the power switch (75) is determined to be normal and there is a request to increase the number of revolutions of the propeller (71), cancel the reduction in the number of revolutions of the propeller (71).

2. The diagnostic device (80) according to claim 1, wherein

   in the power supply system (60), a smoothing capacitor (76) is connected in parallel to the power supply (61) in the power supply path on the inverter side of the power switch (75),
   the diagnostic device (80) further comprises a discharge processing unit that is configured to discharge the smoothing capacitor (76) under the condition that a decrease in the number of revolutions occurs after the output of the shutdown command by the shutdown command unit, and
   the acquisition unit is configured to acquire the difference between the detected voltage before the discharging of the smoothing capacitor (76) by the discharging processing unit and the detected voltage after the discharging of the smoothing capacitor (76) as the voltage change under the situation where the number of revolutions decreases after the output of the shutdown command.

3. The diagnostic device (80) according to claim 2, wherein
   the discharge processing unit is configured to discharge the smoothing capacitor (76) to make the path voltage lower than an electromotive force voltage of the motor (72) at the end of the smoothing capacitor discharge.

4. The diagnostic device (80) according to claim 2, wherein

   the discharge processing unit is configured to discharge the smoothing capacitor (76) multiple times under the situation where the number of revolutions decreases after the output of the shutdown command,
   the acquisition unit is configured to acquire, when the smoothing capacitor (76) is discharged multiple times, the number of revolutions and the path voltage before the first discharge of the smoothing capacitor (76) and after each discharge after the first discharge, respectively,

the diagnostic unit is configured to calculate an approximate straight-line, which is a linear approximation of the relationship between the number of revolutions and the path voltage, using the number of revolutions and the path voltage in three or more combinations acquired by the acquisition unit, and diagnoses the on-failure state of the power switch (75) based on the slope of the approximate straight-line and the scatter of the path voltage relative to the approximate straight-line.

5. The diagnostic device (80) according to claim 4, wherein

the acquisition unit is configured to acquire the number of revolutions and the path voltage before and after the first capacitor discharge by the discharge processing unit as first data and second data respectively, under the condition that the number of revolutions decreases after the output of the shutdown command, and then to acquire the number of revolutions and the path voltage after the second capacitor discharge as third data,

the diagnostic unit is configured to,

in a case that the number of revolutions of the motor (72) is higher than the predetermined value when the second data is acquired, acquire the first to third data and diagnoses the on-failure state of the power switch (75) using the first to third data, and

in a case that the number of revolutions of the motor (72) is lower than the predetermined value when the second data is acquired, acquire the first data and the second data and diagnoses the on-failure state of the power switch (75) using the first data and the second data.

6. The diagnostic device (80) according to claim 1, wherein

the power supply system (60) further comprises a current sensor (28) that is configured to detect the power supply current, which is the current flowing in the power supply (61),

the acquisition unit is configured to acquire the detected current of the current sensor after the output of the shutdown command by the shutdown command unit,

the diagnostic unit is configured to perform a first determination process to determine whether the voltage change is greater than a predetermined voltage threshold and a second determination process to determine whether the detected current is greater than a predetermined current threshold, and

when the voltage change is determined to be smaller than the voltage threshold in the first determination process and the detected current is determined to be larger than the current threshold in the second determination process, the diagnostic unit is configured to diagnose the power switch (75) is in the on-failure state.

7. The diagnostic device (80) according to claim 1, wherein

the power supply system (60) is mounted to a mobile object having a plurality of drive units, each of the drive unit comprising an inverter, a motor, a power switch, and a voltage sensor,

the mobile object can move by driving some of the drive units out of all the drive units,

the shutdown command unit is configured to, when some of the drive units out of a plurality of drive units in the drive state are to be stopped while the mobile object is moving, assume that the switch diagnosis condition is satisfied for the drive unit to be stopped and output the shutdown command.

8. The diagnostic device (80) according to claim 7, further comprising
a power control unit that is configured to output a power command value to the drive unit to which the shutdown command is not output, when stopping the drive of some of the drive units during the movement of the mobile object, and the shutdown command is output by the shutdown command unit for the drive unit to be stopped, the power command value is to maintain the state of movement of the mobile object.

9. A program executed by a computer of a power supply system (60), the power supply system (60) comprising: a power supply (61); an inverter (73) connected to the power supply (61); a motor (72) connected to the inverter (73); a power switch (75) on a power supply path connecting the power supply (61) and the inverter (73); a voltage sensor (77) that detects a path voltage, the path voltage being a voltage of the power supply path on the inverter side of the power switch (75),

wherein the program causes the computer to:

output a shutdown command to shut down the power switch (75) with the control of the inverter (73) stopped when a switch diagnostic condition is satisfied in the conduction state of the power switch (75),
**characterized in that** the program further causes the computer to:

acquire a voltage change, which is the change in the detected voltage of the voltage sensor (77) in response to the change in the number of revolutions of the motor (72) after the output of the shutdown command;
diagnose whether the power switch (75) is in an on-failure state based on the voltage change of at least two different time points, wherein
the inverter (73) is a power conversion circuit with multiple switching elements for each phase,
the path voltage changes in response to the change in the number of revolutions of the motor (72) when the shutdown command is output and the control of the inverter (73) is stopped,
the power supply system (60) is configured to rotate a propeller (71) by the motor (72) in an aerial vehicle that flies with the rotation of the propeller (71),
wherein the program causes the computer to:

when the shutdown command is output by the shutdown command unit, reduce the number of revolutions of the motor (72) along with the number of revolutions of the propeller (71), and,
after the shutdown command is output and the diagnostic unit diagnosed, when the power switch (75) is determined to be normal and there is a request to increase the number of revolutions of the propeller (71), to cancel the reduction in the number of revolutions of the propeller (71).

**Patentansprüche**

1. Diagnosevorrichtung (80), die bei einem Leistungsversorgungssystem (60) anwendbar ist, wobei das Leistungsversorgungssystem (60) aufweist: eine Leistungsversorgung (61), einen Wechselrichter (73), der mit der Leistungsversorgung (61) verbunden ist, wobei der Wechselrichter (73) eine Leistungsumwandlungsschaltung mit mehren Schaltelementen für jede Phase ist, einen Motor (72), der mit dem Wechselrichter (73) verbunden ist, einen Leistungsschalter (75) auf einem Leistungsversorgungspfad, der die Leistungsversorgung (61) und den Wechselrichter (73) verbindet, einen Spannungssensor (77), der eine Pfadspannung erfasst, wobei die Pfadspannung eine Spannung des Leistungsversorgungspfads auf der Wechselrichterseite des Leistungsschalters (75) ist,
wobei die Diagnosevorrichtung (80) aufweist:

eine Abschaltbefehlseinheit, die konfiguriert ist, einen Abschaltbefehl zum Abschalten des Leistungsschalters (75) mit gestoppter Steuerung des Wechselrichters (73) auszugeben, wenn eine Schalterdiagnosebedingung in dem leitenden Zustand des Leistungsschalters (75) erfüllt ist,
**gekennzeichnet durch**
eine Beschaffungseinheit, die konfiguriert ist, eine Spannungsänderung zu beschaffen, die die Änderung in der erfassten Spannung des Spannungssensors (77) in Reaktion auf eine Änderung in der Drehzahl des Motors (72) nach Ausgabe des Abschaltbefehls durch die Abschaltbefehlseinheit ist,
eine Diagnoseeinheit, die konfiguriert ist, auf der Grundlage der Spannungsänderung zumindest zweier unterschiedlicher Zeitpunkte zu diagnostizieren, ob der Leistungsschalter (75) in einem Ein-Fehler-Zustand ist, wobei die Pfadspannung sich in Reaktion auf die Änderung der Drehzahl des Motors (72) ändert, wenn der Abschaltbefehl ausgegeben wird und die Steuerung des Wechselrichters (73) gestoppt wird,
das Leistungsversorgungssystem (60) konfiguriert ist, einen Propeller (71) durch den Motor (72) in einem Luftfahrzeug zu drehen, das mit der Drehung des Propellers (71) fliegt,
die Diagnosevorrichtung (80) weiterhin eine Propellerdrehungssteuerungseinheit aufweist, die konfiguriert ist, wenn der Abschaltbefehl durch die Abschaltbefehlseinheit ausgegeben wird, die Drehzahl des Motors (72) zusammen mit der Drehzahl des Propellers (71) zu reduzieren, und
die Propellerdrehungssteuerungseinheit weiterhin konfiguriert ist, nachdem der Abschaltbefehl ausgegeben worden ist und die Diagnoseeinheit diagnostiziert hat, wenn bestimmt wird, dass der Leistungsschalter (75) normal ist und es eine Anforderung zur Erhöhung der Drehzahl des Propellers (71) gibt, die Reduktion der Drehzahl des Propellers (71) aufzuheben.

2. Diagnosevorrichtung (80) nach Anspruch 1, wobei

in dem Leistungsversorgungssystem (60) ein Glättungskondensator (76) parallel zu der Leistungsversorgung (61) in dem Leistungsversorgungspfad auf der Wechselrichterseite des Leistungsschalters (75) geschaltet ist,

die Diagnosevorrichtung (80) weiterhin eine Entladeverarbeitungseinheit aufweist, die konfiguriert ist, den Glättungskondensator (76) unter der Bedingung zu entladen, dass eine Verringerung in der Drehzahl nach Ausgabe des Abschaltbefehls durch die Abschaltbefehlseinheit auftritt, und

die Beschaffungseinheit konfiguriert ist, die Differenz zwischen der erfassten Spannung vor dem Entladen des Glättungskondensators (76) durch die Entladeverarbeitungseinheit und der erfassten Spannung nach dem Entladen des Glättungskondensators (76) als die Spannungsänderung in der Situation, in der die Drehzahl nach Ausgabe des Abschaltbefehls sich verringert, zu beschaffen.

3. Diagnosevorrichtung (80) nach Anspruch 2, wobei

die Entladeverarbeitungseinheit konfiguriert ist, den Glättungskondensator (76) zu entladen, um die Pfadspannung kleiner als eine Spannung der elektromotorischen Kraft des Motors (72) am Ende des Glättungskondensatorentladens zu machen.

4. Diagnosevorrichtung (80) nach Anspruch 2, wobei

die Entladeverarbeitungseinheit konfiguriert ist, den Glättungskondensator (76) mehrfach in der Situation zu entladen, in der sich die Drehzahl nach der Ausgabe des Abschaltbefehls verringert,

die Beschaffungseinheit konfiguriert ist, wenn der Glättungskondensator (76) mehrfach entladen wird, die Drehzahl und die Pfadspannung jeweils vor dem ersten Entladen des Glättungskondensators (76) und nach jeder Entladung nach der ersten Entladung zu beschaffen,

die Diagnoseeinheit konfiguriert ist, eine angenäherte gerade Linie, die eine Linearannäherung der Beziehung zwischen der Drehzahl und der Pfadspannung ist, unter Verwendung der Drehzahl und der Pfadspannung in drei oder mehr Kombinationen, die durch Beschaffungseinheit beschafft werden, zu berechnen, und den Ein-Fehler-Zustand des Leistungsschalters (75) auf der Grundlage der Steigung der angenäherten geraden Linie und der Streuung der Pfadspannung in Bezug auf die angenäherte gerade Linie zu diagnostizieren.

5. Diagnosevorrichtung (80) nach Anspruch 4, wobei

die Beschaffungseinheit konfiguriert ist, die Drehzahl und die Pfadspannung vor und nach der ersten Kondensatorentladung durch die Entladeverarbeitungseinheit jeweils als erste Daten und zweite Daten unter der Bedingung zu beschaffen, dass sich die Drehzahl nach Ausgabe des Abschaltbefehls verringert, und dann die Drehzahl und die Pfadspannung nach der zweiten Kondensatorentladung als dritte Daten zu beschaffen, die Diagnoseeinheit konfiguriert ist,

in einem Fall, dass die Drehzahl des Motors (72) höher als ein vorbestimmter Wert ist, wenn die zweiten Daten beschafft werden, die ersten und dritten Daten zu beschaffen und den Ein-Fehler-Zustand des Leistungsschalters (75) unter Verwendung der ersten bis dritten Daten zu diagnostizieren, und in einem Fall, dass die Drehzahl des Motors (72) niedriger als der vorbestimmte Wert ist, wenn die zweiten Daten beschafft werden, die ersten Daten und die zweiten Daten zu beschaffen, und den Ein-Fehler-Zustand des Leistungsschalters (75) unter Verwendung der ersten Daten und der zweiten Daten zu diagnostizieren.

6. Diagnosevorrichtung (80) nach Anspruch 1, wobei

das Leistungsversorgungssystem (60) weiterhin einen Stromsensor (28) aufweist, der konfiguriert ist, den Leistungsversorgungsstrom zu erfassen, der der in der Leistungsversorgung (61) fließende Strom ist,

die Beschaffungseinheit konfiguriert ist, den erfassten Strom des Stromsensors nach der Ausgabe des Abschaltbefehls durch die Abschaltbefehlseinheit zu beschaffen,

die Diagnoseeinheit konfiguriert ist, einen ersten Bestimmungsprozess zur Bestimmung, ob die Spannungsänderung größer als ein vorbestimmter Spannungsschwellenwert ist, und einen zweiten Bestimmungsprozess zur Bestimmung, ob der erfasste Strom größer als ein vorbestimmter Stromschwellenwert ist, durchzuführen, und

die Diagnoseeinheit konfiguriert ist, wenn in dem ersten Bestimmungsprozess bestimmt wird, dass die Spannungsänderung kleiner als der Spannungsschwellenwert ist, und in dem zweiten Bestimmungsprozess bestimmt wird, dass der erfasste Strom größer als der Stromschwellenwert ist, zu diagnostizieren, dass der Leistungsschalter (75) in einem Ein-Fehler-Zustand ist.

7. Diagnosevorrichtung (80) nach Anspruch 1, wobei

das Leistungsversorgungssystem (60) an einem mobilen Objekt mit einer Vielzahl von Antriebseinheiten angebracht ist, wobei jede der Antriebseinheiten einen Wechselrichter, einen Motor, einen Leistungsschalter und einen Spannungssensor aufweist,

das mobile Objekt durch Antrieb einiger der Antriebseinheiten von allen Antriebseinheiten sich bewegen kann, die Abschaltbefehlseinheit konfiguriert ist, wenn einige der Antriebseinheiten aus eine Vielzahl von Antriebseinheiten in dem Antriebszustand zu stoppen sind, während sich das mobile Objekt bewegt, anzunehmen, dass die Schalterdiagnosebedingung für die zu stoppende Antriebseinheit erfüllt ist, und den Abschaltbefehl auszugeben.

**8.** Diagnosevorrichtung (80) nach Anspruch 7, weiterhin mit

einer Leistungssteuerungseinheit, die konfiguriert ist, einen Leistungsbefehlswert zu der Antriebseinheit auszugeben, zu der der Abschaltbefehl nicht ausgegeben wird, wenn der Antrieb von einigen der Antriebseinheiten während der Bewegung des mobilen Objekts gestoppt wird, und der Abschaltbefehl durch die Abschaltbefehlseinheit zu der zu stoppenden Antriebseinheit ausgegeben wird, wobei der Leistungsbefehlswert zur Beibehaltung der Bewegung des mobilen Objekts dient.

**9.** Programm, das durch einen Computer eines Leistungsversorgungssystems (60) ausgeführt wird, wobei das Leistungsversorgungssystem (60) aufweist: eine Leistungsversorgung (61), einen Wechselrichter (73), der mit der Leistungsversorgung (61) verbunden ist, einen Motor (72), der mit dem Wechselrichter (73) verbunden ist, einen Leistungsschalter (75) auf einem Leistungsversorgungspfad, der die Leistungsversorgung (61) und den Wechselrichter (73) verbindet, einen Spannungssensor (77), der eine Pfadspannung erfasst, wobei die Pfadspannung eine Spannung des Leistungsversorgungspfads auf der Wechselrichterseite des Leistungsschalters (75) ist, wobei das Programm bewirkt, dass der Computer:

einen Abschaltbefehl zum Abschalten des Leistungsschalters (75) mit gestoppter Steuerung des Wechselrichters (73) ausgibt, wenn eine Schalterdiagnosebedingung in dem leitenden Zustand des Leistungsschalters (75) erfüllt ist,

**dadurch gekennzeichnet, dass** das Programm weiterhin bewirkt, dass der Computer:

eine Spannungsänderung beschafft, die die Änderung in der erfassten Spannung des Spannungssensors (77) in Reaktion auf eine Änderung in der Drehzahl des Motors (72) nach Ausgabe des Abschaltbefehls durch die Abschaltbefehlseinheit ist,

auf der Grundlage der Spannungsänderung von zumindest zwei unterschiedlichen Zeitpunkten diagnostiziert, ob der Leistungsschalter (75) in einem Ein-Fehler-Zustand ist, wobei

der Wechselrichter (73) eine Leistungsumwandlungsschaltung mit mehren Schaltelementen für jede Phase ist,

die Pfadspannung sich in Reaktion auf die Änderung der Drehzahl des Motors (72) ändert, wenn der Abschaltbefehl ausgegeben wird und die Steuerung des Wechselrichters (73) gestoppt wird,

das Leistungsversorgungssystem (60) konfiguriert ist, einen Propeller (71) durch den Motor (72) in einem Flugzeug zu drehen, das mit der Drehung des Propellers (71) fliegt,

wobei das Programm bewirkt, dass der Computer:

wenn der Abschaltbefehl durch die Abschaltbefehlseinheit ausgegeben wird, die Drehzahl des Motors (72) zusammen mit der Drehzahl des Propellers (71) reduziert, und,

nachdem der Abschaltbefehl ausgegeben worden ist und die Diagnoseeinheit diagnostiziert hat, wenn bestimmt wird, dass der Leistungsschalter (75) normal ist und es eine Anforderung zur Erhöhung der Drehzahl des Propellers (71) gibt, die Reduktion der Drehzahl des Propellers (71) aufhebt.

## Revendications

**1.** Dispositif de diagnostic (80) applicable à un système d'alimentation électrique (60), le système d'alimentation électrique (60) comprenant : une alimentation électrique (61) ; un onduleur (73) connecté à l'alimentation électrique (61), dans lequel l'onduleur (73) est un circuit de conversion de puissance avec de multiples éléments de commutation pour chaque phase ;

un moteur (72) connecté à l'onduleur (73) ; un interrupteur (75) sur un trajet d'alimentation électrique reliant l'alimentation électrique (61) et l'onduleur (73) ; un capteur de tension (77) qui détecte une tension de trajet, la tension de trajet étant une tension du trajet d'alimentation électrique du côté onduleur de l'interrupteur (75), dans lequel le dispositif de diagnostic (80) comprend :

une unité d'instruction d'arrêt configurée pour émettre une instruction d'arrêt pour mettre l'interrupteur (75) hors tension, la commande de l'onduleur (73) étant arrêtée lorsqu'une condition de diagnostic de l'interrupteur est satisfaite dans l'état de conduction de l'interrupteur (75) ;
**caractérisé par**
une unité d'acquisition configurée pour acquérir une variation de tension, qui est la variation de la tension détectée du capteur de tension (77) en réponse au changement du nombre de tours du moteur (72) après l'émission de l'instruction d'arrêt par l'unité d'instruction d'arrêt ;
une unité de diagnostic configurée pour diagnostiquer si l'interrupteur (75) est dans un état de défaillance en fonction de la variation de tension d'au moins deux points temporels différents,
dans lequel
la tension de trajet varie en réponse au changement du nombre de tours du moteur (72) lorsque l'instruction d'arrêt est émise et que la commande de l'onduleur (73) est arrêtée,
le système d'alimentation électrique (60) est configuré pour faire tourner une hélice (71) par le moteur (72) dans un véhicule aérien qui vole avec la rotation de l'hélice (71),
le dispositif de diagnostic (80) comprend en outre une unité de commande de rotation d'hélice, configurée pour, lorsque l'instruction d'arrêt est émise par l'unité d'instruction d'arrêt, réduire le nombre de tours du moteur (72) ainsi que le nombre de tours de l'hélice (71), et
l'unité d'instruction de rotation d'hélice est en outre configurée pour, après que l'instruction d'arrêt est émise et que l'unité de diagnostic a émis un diagnostic, annuler la réduction du nombre de tours de l'hélice (71) lorsque l'interrupteur (75) est déterminé comme normal et qu'il y a une demande d'augmentation du nombre de tours de l'hélice (71).

2. Dispositif de diagnostic (80) selon la revendication 1, dans lequel

dans le système d'alimentation électrique (60), un condensateur de lissage (76) est connecté en parallèle à l'alimentation électrique (61) sur le trajet d'alimentation électrique du côté onduleur de l'interrupteur (75),
le dispositif de diagnostic (80) comprend en outre une unité de traitement de décharge configurée pour décharger le condensateur de lissage (76) à condition qu'une diminution du nombre de tours survienne après l'émission de l'instruction d'arrêt par l'unité d'instruction d'arrêt, et
l'unité d'acquisition est configurée pour acquérir la différence entre la tension détectée avant la décharge du condensateur de lissage (76) par l'unité de traitement de décharge et la tension détectée après la décharge du condensateur de lissage (76) au fur et à mesure que la tension varie dans la situation où le nombre de tours diminue après l'émission de l'instruction d'arrêt.

3. Dispositif de diagnostic (80) selon la revendication 2, dans lequel
l'unité de traitement de décharge est configurée pour décharger le condensateur de lissage (76) afin de rendre la tension de trajet inférieure à une tension de force électromotrice du moteur (72) à la fin de la décharge du condensateur de lissage.

4. Dispositif de diagnostic (80) selon la revendication 2, dans lequel

l'unité de traitement de décharge est configurée pour décharger le condensateur de lissage (76) plusieurs fois dans la situation où le nombre de tours diminue après l'émission de l'instruction d'arrêt,
l'unité d'acquisition est configurée pour acquérir, lorsque le condensateur de lissage (76) est déchargé plusieurs fois, le nombre de tours et la tension de trajet avant la première décharge du condensateur de lissage (76) et après chaque décharge après la première décharge, respectivement,
l'unité de diagnostic est configurée pour calculer une ligne droite approximative, qui est une approximation linéaire de la relation entre le nombre de tours et la tension de trajet, en utilisant le nombre de tours et la tension de trajet dans trois combinaisons ou plus acquises par l'unité d'acquisition, et pour diagnostiquer l'état de défaillance de l'interrupteur (75) sur la base de la pente de la ligne droite approximative et de la dispersion de la tension de trajet par rapport à la ligne droite approximative.

5. Dispositif de diagnostic (80) selon la revendication 4, dans lequel

l'unité d'acquisition est configurée pour acquérir le nombre de tours et la tension de trajet avant et après la première décharge du condensateur par l'unité de traitement de décharge comme premières données et deuxièmes données respectivement, à condition que le nombre de tours diminue après l'émission de l'instruction d'arrêt, puis pour acquérir le nombre de tours et la tension de trajet après la seconde décharge du condensateur comme troisièmes données,

l'unité de diagnostic est configurée pour,

dans le cas où le nombre de tours du moteur (72) est supérieur à la valeur prédéterminée lors de l'acquisition des deuxièmes données, acquérir les premières à troisièmes données et diagnostiquer l'état de défaillance de l'interrupteur (75) à l'aide des premières à troisièmes données, et

dans le cas où le nombre de tours du moteur (72) est inférieur à la valeur prédéterminée lors de l'acquisition des deuxièmes données, acquérir les premières données et les deuxièmes données et diagnostiquer l'état de défaillance de l'interrupteur (75) à l'aide des premières données et des deuxièmes données.

6. Dispositif de diagnostic (80) selon la revendication 1, dans lequel

le système d'alimentation électrique (60) comprend en outre un capteur de courant (28) configuré pour détecter le courant d'alimentation électrique, qui est le courant circulant dans l'alimentation électrique (61),

l'unité d'acquisition est configurée pour acquérir le courant détecté du capteur de courant après l'émission de l'instruction d'arrêt par l'unité d'instruction d'arrêt,

l'unité de diagnostic est configurée pour réaliser un premier processus de détermination pour déterminer si la variation de tension est supérieure à un seuil de tension prédéterminé et un second processus de détermination pour déterminer si le courant détecté est supérieur à un seuil de courant prédéterminé, et

lorsque la variation de tension est déterminée comme étant inférieure au seuil de tension par le premier processus de détermination et que le courant détecté est déterminé comme étant supérieur au seuil de courant par le second processus de détermination, l'unité de diagnostic est configurée pour diagnostiquer que l'interrupteur (75) est dans l'état de défaillance.

7. Dispositif de diagnostic (80) selon la revendication 1, dans lequel

le système d'alimentation électrique (60) est monté sur un objet mobile ayant une pluralité d'unités d'entraînement, chacune des unités d'entraînement comprenant un onduleur, un moteur, un interrupteur et un capteur de tension,

l'objet mobile peut se déplacer en entraînant certaines unités d'entraînement parmi toutes les unités d'entraînement,

l'unité d'instruction d'arrêt est configurée pour, lorsque certaines des unités d'entraînement parmi une pluralité d'unités d'entraînement dans l'état d'entraînement doivent être arrêtées pendant que l'objet mobile se déplace, supposer que la condition de diagnostic de l'interrupteur est satisfaite pour l'unité d'entraînement à arrêter et émettre l'instruction d'arrêt.

8. Dispositif de diagnostic (80) selon la revendication 7, comprenant en outre

une unité de commande d'alimentation configurée pour émettre une valeur d'instruction d'alimentation vers l'unité d'entraînement sur laquelle l'instruction d'arrêt n'est pas émise, lors de l'arrêt de l'entraînement de certaines unités d'entraînement pendant le déplacement de l'objet mobile, et l'instruction d'arrêt est émise par l'unité d'instruction d'arrêt pour l'unité d'entraînement à arrêter, la valeur d'instruction d'alimentation étant destinée à maintenir l'état de déplacement de l'objet mobile.

9. Programme exécuté par un ordinateur d'un système d'alimentation électrique (60), le système d'alimentation électrique (60) comprenant : une alimentation électrique (61) ; un onduleur (73) connecté à l'alimentation électrique (61) ; un moteur (72) connecté à l'onduleur (73); un interrupteur (75) sur un trajet d'alimentation électrique reliant l'alimentation électrique (61) et l'onduleur (73) ; un capteur de tension (77) qui détecte une tension de trajet, la tension de trajet étant une tension du trajet d'alimentation électrique du côté onduleur de l'interrupteur (75),

le programme amenant l'ordinateur à :

émettre une instruction d'arrêt pour mettre l'interrupteur (75) hors tension, la commande de l'onduleur (73) étant arrêtée lorsqu'une condition de diagnostic de l'interrupteur est satisfaite dans l'état de conduction de l'interrupteur (75) ;

**caractérisé en ce que** le programme amène en outre l'ordinateur à :

acquérir une variation de tension, qui est la variation de la tension détectée du capteur de tension (77) en réponse au changement du nombre de tours du moteur (72) après l'émission de l'instruction d'arrêt ;
diagnostiquer si l'interrupteur (75) est dans un état de défaillance en fonction de la variation de tension d'au moins deux points temporels différents, dans lequel
l'onduleur (73) est un circuit de conversion de puissance avec de multiples éléments de commutation pour chaque phase,
la tension de trajet varie en réponse au changement du nombre de tours du moteur (72) lorsque l'instruction d'arrêt est émise et que la commande de l'onduleur (73) est arrêtée,
le système d'alimentation électrique (60) est configuré pour faire tourner une hélice (71) par le moteur (72) dans un véhicule aérien qui vole avec la rotation de l'hélice (71),
le programme amenant l'ordinateur à :

lorsque l'instruction d'arrêt est émise par l'unité d'instruction d'arrêt, diminuer le nombre de tours du moteur (72) ainsi que le nombre de tours de l'hélice (71), et,
après que l'instruction d'arrêt est émise et que l'unité de diagnostic a émis un diagnostic, annuler la réduction du nombre de tours de l'hélice (71) lorsque l'interrupteur (75) est déterminé comme normal et qu'il y a une demande d'augmentation du nombre de tours de l'hélice (71).

# FIG.1

# FIG.2

```
                    START

                      │
                      ▼        ┌─ S11
           ╱ ABNORMALITY HAS ╲      NO
          ╱    OCCURRED ?     ╲────────────────────┐
           ╲                 ╱                      │
             ╲      ▲      ╱                        │
               YES │                                │
                   ▼        ┌─ S13                   ▼        ┌─ S12
        ┌─────────────────────┐           ┌───────────────────────┐
        │   INVERTER STOPS     │           │ VEHICLE RUNS NORMALLY │
        └─────────────────────┘           └───────────────────────┘
                   │        ┌─ S14                   │
                   ▼                                 │
        ┌─────────────────────┐                     │
        │ SHUTDOWN COMMAND IS  │                     │
        │      OUTPUT          │                     │
        └─────────────────────┘                     │
                   │        ┌─ S15                   │
                   ▼                                 │
        ┌┬────────────────────┬┐                    │
        ││ DIAGNOSTIC PROCESS IS│                    │
        ││     EXECUTED         │                    │
        └┴────────────────────┴┘                    │
                   │        ┌─ S16                   │
                   ▼                                 │
           ╱                 ╲     NO                │
          ╱  ON-FAILURE STATE ? ╲──────────┐         │
           ╲                 ╱             │         │
               YES │                       │         │
                   ▼    ┌─ S17             ▼   ┌─ S18 │
        ┌─────────────────────┐   ┌───────────────────────┐
        │ PROHIBIT ENGINE DRIVING│ │ CONTINUE ENGINE DRIVING│
        └─────────────────────┘   └───────────────────────┘
                   │◄──────────────────────┘         │
                   ▼                                  │
                  END ◄───────────────────────────────┘
```

# FIG.3

```
        START
          │
          ▼           ┌─ S21
  ┌─────────────────┐
  │  DRIVING FORCE  │
  │ LIMITATION IS   │
  │    STARTED      │
  └─────────────────┘
          │
          ▼           ┌─ S22
  ┌─────────────────┐
  │ ACQUIRE V1 AND N1│
  └─────────────────┘
          │
   ┌──────▼──────┐    ┌─ S23
 NO│  XA ≤ Xth ? │
   └─────────────┘
          │ YES
          ▼           ┌─ S24
  ┌─────────────────┐
  │  DISCHARGE OVER │
  │ A PREDETERMINED │
  │     PERIOD      │
  └─────────────────┘
          │
          ▼           ┌─ S25
  ┌─────────────────┐
  │ ACQUIRE V2 AND N2│
  └─────────────────┘
          │
          ▼           ┌─ S26
  ┌─────────────────┐
  │ CALCULATE ΔV AND ΔN│
  └─────────────────┘
          │
          ▼           ┌─ S27
  ┌─────────────────┐
  │  CALCULATE KA   │
  └─────────────────┘
          │
   ┌──────▼──────┐    ┌─ S28
   │  KA ≥ Kth ? │──── NO ──┐
   └─────────────┘          │
          │ YES             │
          ▼     ┌─ S29      ▼     ┌─ S31
  ┌─────────────┐   ┌──────────────────┐
  │   NORMAL    │   │ ON-FAILURE STATE │
  └─────────────┘   └──────────────────┘
          │                 │
          ▼     ┌─ S30       │
  ┌─────────────┐            │
  │RELEASE DRIVING│          │
  │FORCE LIMITATION│         │
  └─────────────┘            │
          │                 │
          ▼◄────────────────┘
        END
```

# FIG.4

(A)
INVERTER 24

UNDER CONTROL

STOPPED CONTROL

(B)
SHUTDOWN
COMMAND

OUTPUT

NOT OUTPUT

(C)
DRIVING FORCE
LIMITATION

ON

OFF

(D)
VEHICLE SPEED XA

Xth

(E)
THE NUMBER OF
REVOLUTIONS NA

N1

Nth

N2

(F)
DISCHARGE

ON

OFF

(G)
PATH VOLTAGE VA

V1

VB

V2

t1  t2  t3    t4  t5  t6  t7    TIME

# FIG.5

(A)
INVERTER 24

UNDER CONTROL

STOPPED CONTROL

(B)
SHUTDOWN
COMMAND

OUTPUT

NOT OUTPUT

(C)
DRIVING FORCE
LIMITATION

ON

OFF

(D)
VEHICLE SPEED XA

N1

Xth

N2

0

(E)
THE NUMBER OF
REVOLUTIONS NA

Nth

0

(F)
DISCHARGE

ON

OFF

(G)
PATH VOLTAGE VA

VB

V1

V2

t1  t2  t3    t4  t5  t6  t7  t8    TIME

# FIG.6

(A)

(B)

# FIG.7

START

S21
DRIVING FORCE
LIMITATION IS STARTED

S22
ACQUIRE V1 AND N1

S23
XA ≤ Xth ?  — NO

YES
S24
DISCHARGE OVER
A PREDETERMINED PERIOD

S25
ACQUIRE V2 AND N2

S26
CALCULATE $\Delta V$ AND $\Delta N$

S27
CALCULATE KA

S28
KA ≥ Kth ?  — NO

YES

S41
ACQUIRE IA

S42
| IA | ≥ Ith ?  — NO

YES

S29
NORMAL

S31
ON-FAILURE STATE

S30
RELEASE DRIVING
FORCE LIMITATION

END

# FIG.8

```
        ┌─────────────┐
        │    START    │
        └─────────────┘
               │
               ▼                S21
┌────────────────────────────────────┐
│ DRIVING FORCE LIMITATION IS STARTED │
└────────────────────────────────────┘
               │
               ▼                S22
┌────────────────────────────────────┐
│         ACQUIRE V1 AND N1          │
└────────────────────────────────────┘
               │
               ▼                S23
NO ◄───────< XA ≤ Xth ? >
               │ YES
               ▼                S24
┌────────────────────────────────────┐
│          DISCHARGE OVER            │
│     A PREDETERMINED PERIOD         │
└────────────────────────────────────┘
               │
               ▼                S25
┌────────────────────────────────────┐
│         ACQUIRE V2 AND N2          │
└────────────────────────────────────┘
               │
               ▼                S51
         < N2 < NK ? >──── YES ────────────────────────┐
               │ NO          S52                         │
               ▼                                         ▼            S26
┌────────────────────────────────────┐    ┌─────────────────────────────┐
│          DISCHARGE OVER            │    │   CALCULATE ΔV AND ΔN      │
│     A PREDETERMINED PERIOD         │    └─────────────────────────────┘
└────────────────────────────────────┘                  │
               │                S53                      ▼            S27
┌────────────────────────────────────┐    ┌─────────────────────────────┐
│         ACQUIRE V3 AND N3          │    │       CALCULATE KA          │
└────────────────────────────────────┘    └─────────────────────────────┘
               │                S54                      │            S28
┌────────────────────────────────────┐         YES  < KA ≥ Kth ? >
│       CALCULATE KA AND ΔK          │          │         │ NO
└────────────────────────────────────┘          │         │
               │                S55              │         │
         < KA ≥ Kth ? >──── NO ──┐              │         │
               │ YES       S56   ▼              │         ▼            S41
               │          < ΔK ≤ ΔKth ? >── YES ┘   ┌────────────────┐
               │                  │ NO                │   ACQUIRE IA   │
               │◄─────────────────┘                   └────────────────┘
               │◄──────────────── NO ──────────────          │        S42
               │                               < |IA| ≥ Ith ? >
               ▼                S29                       │ YES     S31
┌────────────────────────┐              ┌────────────────────────┐
│        NORMAL          │              │    ON-FAILURE STATE    │
└────────────────────────┘              └────────────────────────┘
               │                S30                      │
┌────────────────────────────────────┐                  │
│ RELEASE DRIVING FORCE LIMITATION   │                  │
└────────────────────────────────────┘                  │
               │                                         │
               ▼◄────────────────────────────────────────┘
        ┌─────────────┐
        │     END     │
        └─────────────┘
```

# FIG.9

(A)
INVERTER 24

UNDER CONTROL

STOPPED CONTROL

(B)
SHUTDOWN
COMMAND

OUTPUT

NOT OUTPUT

(C)
DRIVING FORCE
LIMITATION

ON

OFF

(D)
VEHICLE SPEED XA

$Xth$

(E)
THE NUMBER OF
REVOLUTIONS NA

N1

$Nth$

N2

NK

N3

(F)
DISCHARGE

ON

OFF

(G)
PATH VOLTAGE VA

VB

V1

V2

0

V3

t2
t1   t3        t4   t6        t11   t12        t7   TIME
t5        t11   t13

# FIG.10

(A)
INVERTER 24    UNDER CONTROL

STOPPED CONTROL

(B)
SHUTDOWN
COMMAND    OUTPUT

NOT OUTPUT

(C)
DRIVING FORCE
LIMITATION    ON

OFF

(D)
VEHICLE SPEED XA    Xth

(E)
THE NUMBER OF
REVOLUTIONS NA

N1

N2

NK

N3

0

0

(F)
DISCHARGE    ON

OFF

(G)
PATH VOLTAGE VA    VB

V1    V2    V3

t2    t4    t6    t12 t13    t8    TIME

t1    t3    t5    t11    t7

# FIG.11

(A)

(B)

(C)

# FIG.12

# FIG.13

```
        START
          │
          ▼           S61
  ╱CONDITION IS SATISFIED ?╲──NO──┐
          │                        │
         YES                       │
          │          S62           │
          ▼                        │
  ┌─────────────────┐              │
  │  INVERTER STOPS │              │
  └─────────────────┘              │
          │          S63           │
          ▼                        │
  ┌─────────────────┐              │
  │      OUTPUT     │              │
  │ SHUTDOWN COMMAND│              │
  └─────────────────┘              │
          │          S64           │
          ▼                        │
  ┌─────────────────┐              │
  │ ACQUIRE V11 AND N11            │
  └─────────────────┘              │
          │          S65           │
          ▼                        │
  ┌─────────────────┐              │
  │ DISCHARGE CAPACITOR            │
  └─────────────────┘              │
          │          S66           │
          ▼                        │
  ┌─────────────────┐              │
  │ ACQUIRE V12 AND N12            │
  └─────────────────┘              │
          │          S67           │
          ▼                        │
  ┌─────────────────┐              │
  │ CALCULATE △V AND △N            │
  └─────────────────┘              │
          │          S68           │
          ▼                        │
  ╱ON-FAILURE STATE ?╲──NO──►      │
          │                        │
         YES         S69           │
          ▼                        │
  ┌─────────────────┐              │
  │ FAILURE INFORMATION IS         │
  │  STORED IN MEMORY │            │
  └─────────────────┘              │
          │◄──────────────────────┘
          ▼
        END
```

# FIG.14

START

S71
CONDITION IS SATISFIED ? — NO

YES

S72
CALCULATE POWER
COMMAND VALUE TO
MAINTAIN THE FLIGHT

S73
INVERTER STOPS

S74
OUTPUT
SHUTDOWN COMMAND

S75
DIAGNOSIS

S76
NORMAL ? — NO

YES

S77
REQUEST TO
INCREASE THE NUMBER OF — NO
REVOLUTIONS ?

YES

S78
RE-CALCULATEPOWER
COMMAND VALU

S79
RESTART PROPELLER UNIT

S80
FAILURE INFORMATION IS
STORED IN MEMORY

END

# FIG.15

```
            START
              |
              |          S22
    ┌─────────────────────┐
    │   ACQUIRE V1 AND N1  │
    └─────────────────────┘
              |
              |          S91
    ┌─────────────────────┐
    │ GEAR RATIO IS INCREASED │
    └─────────────────────┘
              |
              |          S24
    ┌─────────────────────┐
    │   DISCHARGE OVER     │
    │ A PREDETERMINED PERIOD │
    └─────────────────────┘
              |
              |          S25
    ┌─────────────────────┐
    │   ACQUIRE V2 AND N2  │
    └─────────────────────┘
              |
              |          S26
    ┌─────────────────────┐
    │  CALCULATE ΔV AND ΔN │
    └─────────────────────┘
              |
              |          S27
    ┌─────────────────────┐
    │     CALCULATE KA     │
    └─────────────────────┘
              |
              |          S28
        ┌──────────┐   NO
        < KA ≥ Kth ? >──────────┐
        └──────────┘            |
            YES                 |
              |     S29         |          S31
    ┌─────────────────┐   ┌─────────────────┐
    │     NORMAL      │   │ ON-FAILURE STATE │
    └─────────────────┘   └─────────────────┘
              |                 |
              |     S30         |
    ┌─────────────────┐         |
    │  RELEASE DRIVING │        |
    │  FORCE LIMITATION │       |
    └─────────────────┘         |
              |                 |
              |←────────────────┘
            END
```

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009183134 A
- US 2011221374 A1
- JP 2006280070 A
- US 2013106423 A1